# EUROPEAN PATENT APPLICATION

(11) **EP 2 690 495 A1**
(43) Date of publication of application: **29.01.2014**
(21) Application number: 13177390.5
(22) Date of filing: 22.07.2013
(51) Int. Cl.: G03F 7/004, B41C 1/10, G03F 7/105, G03F 7/30, G03F 7/027

(54) **Lithographic printing plate precursor and plate making method thereof**

(30) Priority: 27.07.2012 JP 2012167651
(71) Applicant: Fujifilm Corporation, Minato-ku Tokyo (JP)
(72) Inventor: Fujiki, Yuzo, Shizuoka (JP)
(74) Representative: HOFFMANN EITLE

(57) **Abstract**

A lithographic printing plate precursor includes a support and an image-recording layer capable of forming an image by removing an unexposed area by supplying printing ink and dampening water on a printing machine after image exposure, and the image-recording layer contains (A) an infrared absorbing agent, (B) a radical generator, (C) a polyrnerizable compound and (D) a mesoporous silica having a color changing compound incorporated in the mesoporous silica.

## Description

### FIELD OF THE INVENTION

The present invention relates to a lithographic printing plate precursor and a plate making method thereof, and in particular, to a lithographic printing plate precursor which is excellent in visibility of visible image after image exposure (plate inspection property), on-press development property and printing durability and a plate making method thereof.

### BACKGROUND OF THE INVENTION

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-forming layer, image-recording layer) is heretofore used. Specifically, the PS plate is exposed through a mask, for example, a lith film, and then subjected to development processing, for example, with an alkaline developing solution to remove the unnecessary image-forming layer corresponding to the non-image area by dissolving while leaving the image-forming layer corresponding to the image area, thereby obtaining the lithographic printing plate.

Simplification proceeds in the plate making operation in which a lithographic printing plate is produced from a lithographic printing plate precursor, and with respect to the image exposure, nowadays the lithographic printing plate can be obtained by a CTP (computer-to-plate) technology. Specifically, a lithographic printing plate precursor is directly subjected to scanning exposure using laser or laser diode without using a lith film and developed to obtain the lithographic printing plate.

Further, with respect to the development processing after image exposure, an environmental problem on waste liquid discharged accompanying the wet treatment comes to the front, and simplification of the development processing or non-processing has been pursued. As one method of simple development processing method, a method referred to as an "on-press development" is practiced. Specifically, according to the method after exposure of a lithographic printing plate precursor, the lithographic printing plate precursor is mounted as it is on a printing machine without conducting conventional development processing and removal of the unnecessary area of image-recording layer is performed at an early stage of usual printing process.

In the simplification of plate making operation as described above, a system using a lithographic printing plate precursor capable of being handled in a bright room and a light source is preferred from the standpoint of ease in operation. Thus, as the light source, a semiconductor laser emitting an infrared ray having a wavelength of 760 to 1,200 or a solid laser, for example, YAG laser, is used.

As the lithographic printing plate precursor capable of undergoing on-press development, for instance, a lithographic printing plate precursor having provided on a hydrophilic support, an image-forming layer (heat-sensitive layer) containing microcapsules having a polymerizable compound encapsulated therein is described in JP-A-2001-277740 (the term "JP-A" as used herein means an "unexamined published Japanese patent application") and JP-A-2001-277742. A lithographic printing plate precursor having provided on a support, an image-forming layer (photosensitive layer) containing an infrared absorbing agent, a radical polymerization initiator and a polymerizable compound is described in JP-A-2002-287334. A lithographic printing plate precursor capable of undergoing on-press development having provided on a support, an image-forming layer containing a polymerizable compound and a graft polymer having a polyethylene oxide chain in its side chain or a block polymer having a polyethylene oxide block is described in U.S. Patent Publication No. 2003/0064318.

In general, an operation (plate inspection) for inspection and discrimination of image formed on a printing plate is carried out in order to examine whether the image is recorded on the printing plate as intended, in advance of mounting the printing plate on a printing machine. In a conventional lithographic printing plate precursor subjected to a development processing step, since a color image is obtained due to the development processing by means of coloration of the image-recording layer it is easily performed to confirm the image formed before the mounting the printing plate on a printing machine.

However, with respect to the lithographic printing plate precursor of the on-press development type or non-processing (non-development) type without accompanying the development processing, the image is not recognized on the printing plate in the step of mounting it on a printing machine, and thus the plate inspection can not be performed. In particular, it is vital in the printing operation to determine whether a registry guide (register mark) which acts as a landmark for the register in multicolor printing is recorded. Therefore, in the lithographic printing plate precursor of the on-press development type or non-processing (non-development) type, a means for confirming the image, that is, color change or decoloration in the exposed area to form a so-called print-out image is required at the stage of exposure.

A lithographic printing plate precursor is proposed wherein a compound capable of generating an acid, base or radical by means of light or heat and a compound capable of undergoing color change upon interaction with the acid, base or radical generated are used in order to form a print-out image (for example, see JP-A-11-277927). Also, it is proposed to utilize color change of thermally decomposable compound as the print-out agent of a direct-drawing type lithographic printing plate precursor having a heat-sensitive layer (for example, see JP-A-2000-335129). Further, it is proposed to use a thermally decomposable dye having a thermally decomposable temperature of 250°C or below as the print-out agent (for example, see JP-A-2003-191657).

Further, it is described in JP-A-2007-90850 that a print-out image having a good visibility and a level capable of performing plate inspection is obtained by a system containing an infrared absorbing agent of cyanine dye having a 5-membered ring in its methine chain and a radical generator.

According to these proposals, although the color change or decoloration occurs in the exposed area and the plate inspection property increases to some extent, it is still insufficient and further improvement in the plate inspection property is desired from the practical standpoint.

In particular, in case of the lithographic printing plate precursor of on-press development type, since dampening water penetrates into an image-recording layer in the non-image area and the image-recording layer in the non-image area is removed with dampening water and ink, the image-recording layer is needed to be hydrophilic. On the contrary, since a compound which causes change in color is ordinarily hydrophobic, incorporation of the compound into the image-recording layer decreases the hydrophilicity of the image-recording layer and deteriorates on-press development property. Further, when the compound which causes change in color is present in a hydrophilic image-recording layer, the compound is apt to decompose and a compound changed in color after exposure is also apt to decompose so that the change in color becomes small and the change in color tends to decrease with the lapse of time. Therefore, it is heretofore difficult to achieve a balance between the plate inspection property and the on-press development property.

On the other hand, it is described in JP-A-2010-280512 that an inorganic organic composite material formed from an inorganic substance composed of aluminum-substituted mesoporous silica and an organic substance in which an electron-donating moiety and an electron-accepting moiety are connected is employed as a photocatalyst, a photosensitizer, a dye, an oxidizing agent, a reducing agent, a battery, a dye-sensitized solar cell, an organic EL element or the like.

### SUMMARY OF THE INVENTION

An object of the present invention is to provide a lithographic printing plate precursor, particularly, a lithographic printing plate precursor of on-press development type, which is excellent in visibility of visible image after image exposure (plate inspection property), on-press development property and printing durability and a plate making method thereof.
(1) A lithographic printing plate precursor comprising a support and an image-recording layer capable of forming an image by removing an unexposed area by supplying printing ink and dampening water on a printing machine after image exposure, wherein the image-recording layer contains (A) an infrared absorbing agent, (B) a radical generator, (C) a polymerizable compound and (D) a mesoporous silica having a color changing compound incorporated therein.
(2) The lithographic printing plate precursor as described in (1), wherein the color changing compound in the mesoporous silica having a color changing compound incorporated therein is a compound which causes change in color with light, an acid or heat.
(3) The lithographic printing plate precursor as described in (2), wherein the color changing compound is a compound which causes change in color with light.
(4) The lithographic printing plate precursor as described in (3), wherein the compound which causes change in color with light is a cyanine dye.
(5) The lithographic printing plate precursor as described in (4), wherein the cyanine dye is a cyanine dye represented by formula (2) shown below. 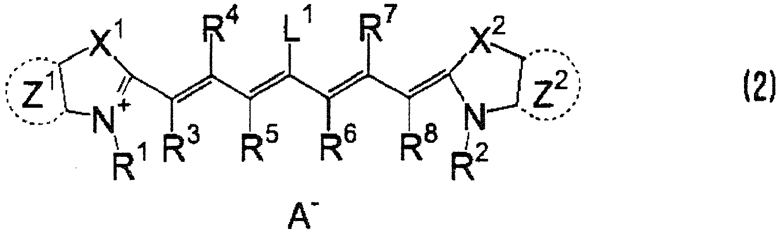 In formula (2), L¹ represents a hydrogen atom, a halogen atom, -NPh₂ or -Y³-L². Y³ represents an oxygen atom, a nitrogen atom or a sulfur atom. L² represents an alkyl group, an aryl group, a heterocyclic group or a hydrocarbon group having from 1 to 12 carbon atoms and containing a hetero atom. X¹ and X² each independently represents a sulfur atom, an oxygen atom or a dialkylmethylene group having 12 or less carbon atoms. Z¹ and Z² each independently represents an aromatic ring or a heteroaromatic ring. R¹ and R² each independently represents a hydrocarbon group. R³, R⁴, R⁷ and R⁸ each independently represents a hydrogen atom or a hydrocarbon group having 12 or less carbon atoms. R⁵ and R⁶ each independently represents a hydrocarbon group, or R⁵ and R⁶ may be combined with each other to form a 5-membered or 6-membered ring. A⁻ represents a counter anion.
(6) The lithographic printing plate precursor as described in (5), wherein the cyanine dye is a cyanine dye represented by formula (3) shown below. 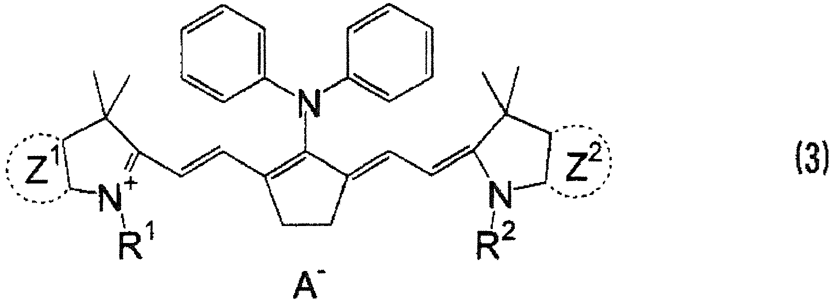 In formula (3), Z¹ and Z² each independently represents an aromatic ring or a heteroaromatic ring. R¹ and R² each independently represents a hydrocarbon group. A⁻ represents a counter anion.
(7) The lithographic printing plate precursor as described in any one of (4) to (6), wherein the mesoporous silica having a cyanine dye incorporated therein further contains an onium salt.
(8) The lithographic printing plate precursor as described in (7), wherein the onium salt is an iodonium salt or a sulfonium salt.
(9) The lithographic printing plate precursor as described in (2), wherein the color changing compound is a compound which causes change in color with an acid.
(10) The lithographic printing plate precursor as described in (9), wherein the compound which causes change in color with an acid is a compound represented by formula (II-3) shown below. 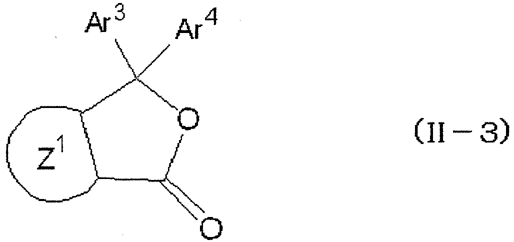 In formula (II-3), Ar³ and Ar⁴, which may be the same or different, each represents an aryl group, a heterocyclic group, an alkenyl group or an alkynyl group, and Z¹ represents an aromatic hydrocarbon ring or a heterocyclic ring.
(11) The lithographic printing plate precursor as described in (2), wherein the color changing compound is a compound which causes change in color with heat.
(12) The lithographic printing plate precursor as described in (11), wherein the compound which causes change in color with heat is a compound represented by formula (IB) shown below. 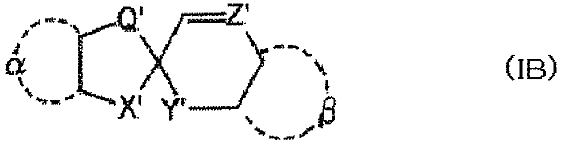 In formula (IB), X' represents NR¹, O or S. R¹ represents an alkyl group having from 1 to 20 carbon atoms, an alkenyl group having from 2 to 20 carbon atoms, an alkynyl group having from 2 to 20 carbon atoms, an aralkyl group having from 7 to 20 carbon atoms or an aryl group having from 6 to 19 carbon atoms. α and β each represents an atomic group which forms a ring together with the carbon atoms connected. Q' represents O, S or CR²R³. R² and R³ each independently represents an alkyl group having from 1 to 20 carbon atoms, an alkenyl group having from 2 to 20 carbon atoms, an alkynyl group having from 2 to 20 carbon atoms, an aralkyl group having from 7 to 20 carbon atoms or an aryl group having from 6 to 19 carbon atoms, or R² and R³ may be combined with each other to from a ring having from 3 to 20 carbon atoms. Y' represents N, O or S. Z' represents CH or N.
(13) The lithographic printing plate precursor as described in any one of (1) to (12), wherein the image-recording layer contains (F) a borate compound.
(14) The lithographic printing plate precursor as described in (13), wherein the borate compound is a tetraaryl borate.
(15) The lithographic printing plate precursor as described in any one of (1) to (14), which comprises a protective layer on the image-recording layer.
(16) A plate making method comprising imagewise exposing the lithographic printing plate precursor as described in any one of (1) to (15) with infrared laser, mounting the exposed lithographic printing plate precursor on a printing machine and supplying dampening water and ink to remove the image-recording layer in an unexposed area.

According to the present invention, lithographic printing plate precursor, particularly, a lithographic printing plate precursor of on-press development type, which is excellent in visibility of visible image after image exposure (plate inspection property), on-press development property and printing durability and a plate making method thereof can be provided.

### DETAILED DESCRIPTION OF THE INVENTION

According to the invention, by introducing a mesoporous silica having a color changing compound incorporated therein into an image-recording layer of a lithographic printing plate precursor, a lithographic printing plate which is excellent in both visibility of visible image after image exposure (plate inspection property), on-press development property and printing durability can be obtained by conducting plate making.

The functional mechanism of the invention is not quite clear but it is believed that by using a mesoporous silica having a relatively hydrophilic surface and incorporating a color changing compound into the inside of pores of the mesoporous silica, the color changing compound can be isolated from the hydrophilic environment of image-recording layer while maintaining the hydrophilicity of image-recording layer. Further, it is estimated that since the color changing compound is incorporated into the pores of the mesoporous silica and isolated from other components of the image-recording layer, decomposition of the color changing compound is inhibited and the color changing reaction is accelerated. It is also estimated that since the compound is isolated from other components of the image-recording layer even after the color change, the fading reaction is prevented. Moreover, it is estimated that since the mesoporous silica cushions the shock at the time of printing, the printing durability is improved.

The lithographic printing plate precursor according to the invention comprises an image-recording layer and a support, wherein the image-recording layer contains (A) an infrared absorbing agent, (B) a radical generator, (C) a polymerizable compound, and (D) a mesoporous silica having a color changing compound incorporated therein. The lithographic printing plate precursor according to the invention can produce a lithographic printing plate by on-press development on a printing machine after image exposure.

The lithographic printing plate precursor according to the invention may comprise an undercoat layer between the support and the image-recording layer, if desired. Also, the lithographic printing plate precursor according to the invention may comprise a protective layer on the image-recording layer.

The lithographic printing plate precursor according to the invention will be described below.

### [Image-recording layer]

The image-recording layer according to the invention contains (A) an infrared absorbing agent, (B) a radical generator, (C) a polymerizable compound, and (D) a mesoporous silica having a color changing compound incorporated therein and is capable of being removed with at least any of printing ink and dampening water.

The image-recording layer according to the invention may contain a component, for example, (E) a binder polymer, (F) a borate compound or (G) a polymer fine particle, in addition to the components described above, if desired. Further, the image-recording layer may contain, if desired, a known compound other than the components described above.

Respective components which can be contained in the image-recording layer will be described in order below.

### (A) Infrared absorbing agent

An infrared absorbing agent (A) which can be used in the invention is preferably a dye or pigment having an absorption maximum in a wavelength range from 760 to 1,200 nm. In the invention, a dye is preferred from the standpoint of increasing the print-out property.

As the dye, commercially available dyes and known dyes described in literatures, for example, Senryo Binran (Dye Handbook) compiled by The Society of Synthetic Organic Chemistry, Japan (1970) can be utilized. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Examples of preferred dye include cyanine dyes described, for example, in JP-A-58-125246, JP-A-59-84356 and JP-A-60-78787, methine dyes described, for example, in JP-A-58-173696, JP-A-58-181690 and JP-A-58-194595, naphthoquinone dyes described, for example, in JP-A-58-112793, JP-A-58-224793, JP-A-59-48187, JP-A-59-73996, JP-A-60-52940 and JP-A-60-63744, squarylium dyes described, for example, in JP-A-58-112792, and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 (the term "JP-B" as used herein means an "examined Japanese patent publication") and JP-B-5-19702 are also preferably used. Other preferred examples of the dye include near infrared absorbing dyes represented by formulae (I) and (II) in U.S. Patent 4,756,993.

Of the dyes, cyanine dyes, squarylium dyes, pyrylium dyes, nickel thiolate complexes and indolenine cyanine dyes are particularly preferred.

As the cyanine dye, a cyanine dye represented by formula (1) shown below is preferably used.

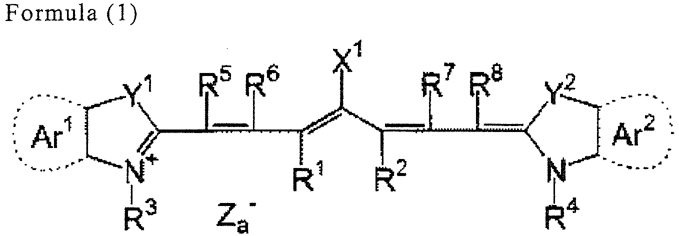

In formula (1), X¹ represents a hydrogen atom, a halogen atom, -N(L¹)₂, -X²-L¹ or a group shown below. X² represents an oxygen atom or a sulfur atom. L¹ represents a hydrocarbon group having from 1 to 12 carbon atoms, an aromatic ring group containing a hetero atom or a hydrocarbon group having from 1 to 12 carbon atoms and containing a hetero atom. The hetero atom as used herein indicates a nitrogen atom, a sulfur atom, an oxygen atom, a halogen atom or a selenium atom. In the group shown below, Xa⁻ has the same meaning as Za⁻ defined hereinafter, and R^{a} represents a hydrogen atom or a substituent selected from an alkyl group, an aryl group, a substituted or unsubstituted amino group and a halogen atom. From the standpoint of improvement in the visibility, X¹ is preferably -NPh₂.

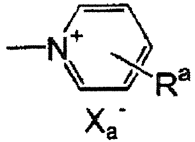

In formula (1), R¹ and R² each independently represents a hydrocarbon group having from 1 to 12 carbon atoms. In view of the preservation stability of a coating solution for image-recording layer, it is preferred that R¹ and R² each represents a hydrocarbon group having two or more carbon atoms. Further, it is preferred that R¹ and R² are combined with each other to form a 5-membered or 6-membered ring. From the standpoint of improvement in the visibility, it is particularly preferred that R¹ and R² are combined with each other to form a 5-membered ring.

In formula (1), Ar¹ and Ar², which may be the same or different, each represents an aromatic hydrocarbon group which may have a substituent. Preferred examples of the aromatic hydrocarbon group include a benzene ring group and a naphthalene ring group. Also, preferred examples of the substituent include a hydrocarbon group having 12 or less carbon atoms, a halogen atom and an alkoxy group having 12 or less carbon atoms. From the standpoint of improvement in the visibility, the substituent is preferably an electron donating group, and specifically, more preferably an alkoxy group having 12 or less carbon atoms or an alkyl group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms which may have a substituent. Preferred examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred.

In formula (1), Za⁻ represents a counter anion. However, Za⁻ is not necessary when the cyanine dye represented by formula (1) has an anionic substituent in the structure thereof and neutralization of charge is not needed. In view of the preservation stability of a coating solution for image-recording layer, preferred examples of the counter ion for Za⁻ include a halide ion, a perchlorate ion, a tetrafluoroborate ion, a hexafluorophosphate ion, a sulfonate ion and an organic borate ion, for example, a tetraphenyl borate ion, and more preferred examples thereof include a perchlorate ion, a hexafluorophosphate ion, an arylsulfonate ion and an organic borate ion, for example, a tetraphenyl borate ion.

As a more preferred example of the cyanine dye, a dye represented by formula (2) shown below is exemplified.

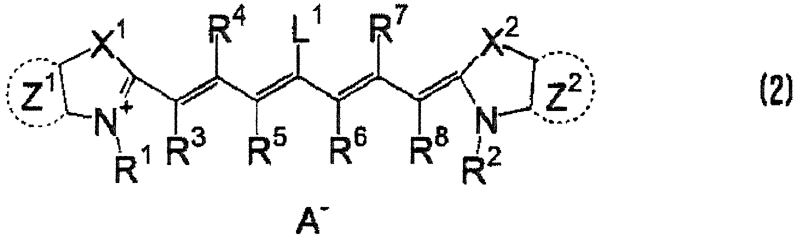

In formula (2), L¹ represents a hydrogen atom, a halogen atom, -NPh₂ or -Y³-L². Y³ represents an oxygen atom, a nitrogen atom or a sulfur atom. L² represents an alkyl group, an aryl group, a heteroaromatic ring group (the hetero atom represents a nitrogen atom, a sulfur atom, an oxygen atom, a halogen atom or a selenium atom) or a hydrocarbon group having from 1 to 12 carbon atoms and containing a hetero atom.

X¹ and X² each independently represents a sulfur atom, an oxygen atom or a dialkylmethylene group having 12 or less carbon atoms. Z¹ and Z² each independently represents an aromatic ring or a heteroaromatic ring.

R¹ and R² each independently represents a hydrocarbon group. R³, R⁴, R⁷ and R⁸ each independently represents a hydrogen atom or a hydrocarbon group having 12 or less carbon atoms. R⁵ and R⁶ each independently represents a hydrocarbon group, or R⁵ and R⁶ may be combined with each other to form a 5-membered or 6-membered ring. A⁻ represents a counter anion and has the same meaning as Za⁻ defined in formula (1) above, and preferred examples thereof are also the same.

Each of the substituents and ring structures described above may have a substituent, and examples of the substituent capable of being introduced include an alkyl group having from 1 to 12 carbon atoms, an aryl group having from 6 to 12 carbon atoms, a halogen atom, an alkoxy group having from 1 to 12 carbon atoms, an aryloxy group having from 6 to 12 carbon atoms, a hydroxy group, an amino group, a carbonyl group, a carboxyl group, a sulfo group and a silyl group.

As a still more preferred example of the cyanine dye, a dye represented by formula (3) shown below is exemplified.

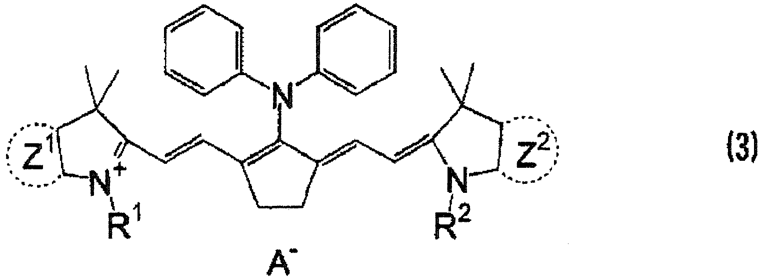

In formula (3), Z¹ and Z² each independently represents an aromatic ring or a heteroaromatic ring. R¹ and R² each independently represents a hydrocarbon group. A⁻ represents a counter anion and has the same meaning as Za⁻ defined in formula (1) above, and preferred examples thereof are also the same.

Each of the substituents and ring structures described above may have a substituent, and examples of the substituent capable of being introduced include an alkyl group having from 1 to 12 carbon atoms, an aryl group having from 6 to 12 carbon atoms, a halogen atom, an alkoxy group having from 1 to 12 carbon atoms, an aryloxy group having from 6 to 12 carbon atoms, a hydroxy group, an amino group, a carbonyl group, a carboxyl group, a sulfo group and a silyl group.

Specific examples of the cyanine dye represented by formula (1) which can be preferably used in the invention are set forth below, but the invention should not be construed as being limited thereto.

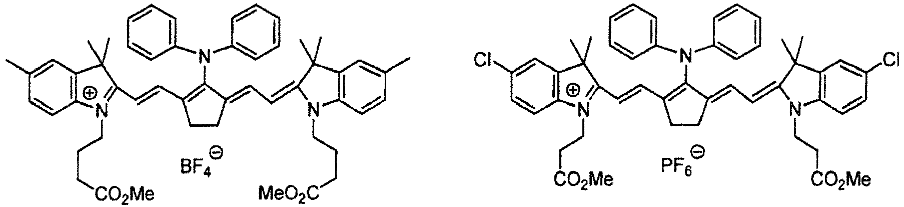

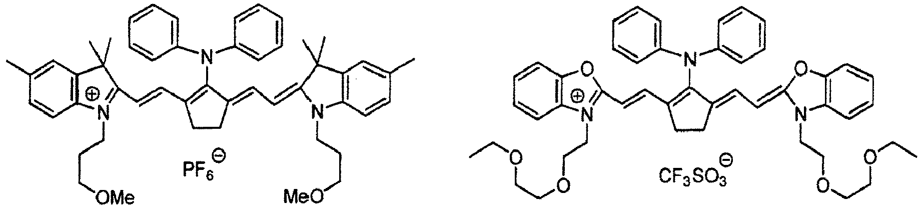

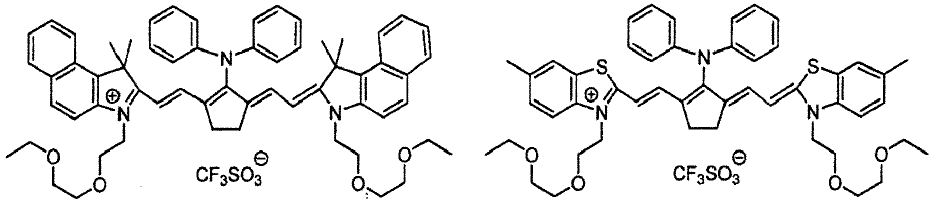

Examples of the infrared absorbing pigment which can be used in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black.

The pigment may be used without undergoing surface treatment or may be used after the surface treatment. For the surface treatment, a method of coating a resin or wax on the surface of pigment, a method of attaching a surfactant to the pigment surface and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984), and Saishin Ganryo Oyo Gijutsu (Newest Application on Technologies for Pigments), CMC Publishing Co., Ltd. (1986).

The particle size of pigment is preferably in a range from 0.01 to 10 µm, more preferably in a range from 0.05 to 1 µm, particularly preferably in a range from 0.1 to 1 µm. In the range described above, good stability of the pigment dispersion in the coating solution for image-recording layer and good uniformity of the image-recording layer is obtained.

For dispersing the pigment, a known dispersion technique for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganryo Oyo Gijutsu (Newest Application on Technologies for Pigments), CMC Publishing Co., Ltd. (1986).

The content of the infrared absorbing agent is preferably from 0.001 to 50% by weight, more preferably from 0.005 to 30% by weight, particularly preferably from 0.01 to 10% by weight, based on the total solid content of the image-recording layer. In the range described above, high sensitivity is obtained without exerting undesirable influence on the uniformity and film strength of the image-recording layer. (B) Radical generator

The radical generator (B) which can be used in the invention is a compound which initiates or accelerates polymerization of a polymerizable compound (C). The radical generator includes, for example, known thermal polymerization initiators, compounds containing a bond having small bond dissociation energy and photopolymerization initiators.

The radical generator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound and (k) an onium salt compound.

As the organic halide (a), for example, compounds described in Paragraph Nos. [0022] to [0023] of JP-A-2008-195018 are preferred.

As the carbonyl compound (b), for example, compounds described in Paragraph No. [0024] of JP-A-2008-195018 are preferred.

As the azo compound (c), for example, azo compounds described in JP-A-8-108621 are exemplified.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-6I-166544 and JP-A-2002-328465 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848 and JP-A-2008-195018, sulfonium salts described in European Patents 370,693, 390,214, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., Macromolecules, 10 (6), 1307 (1977) and J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

As preferred radical generators, the onium salt, in particular, the iodonium salt, the sulfonium salt or the azinium salt, and the hexaarylbiimidazole compound are exemplified. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate and tris(4-chlorophenyl)sulfonium 3,5-bis(methoxycarbonyl)benzenesulfonate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

Examples of the hexaarylbiimidazole compound include 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetrakis(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The content of the radical generator is preferably from 0.1 to 50% by weight, more preferably from 0.5 to 30% by weight, particularly preferably from 0.8 to 20% by weight, based on the total solid content of the image-recording layer. In the range described above, good sensitivity and good stain resistance in the non-image area at the time of printing are obtained. (C) Polymerizable compound

The polymerizable compound (C) which can be used in the invention is an addition-polymerizable compound having at least one ethylenically unsaturated double bond, and it is preferably selected from compounds having at least one, preferably two or more, terminal ethylenically unsaturated double bonds. Such compounds are widely known in the field of art and they can be used in the invention without any particular restriction. The polymerizable compound has a chemical form, for example, a monomer, a prepolymer, specifically, a dimer, a trimer or an oligomer, or a mixture thereof, or a (co)polymer thereof.

Specific examples of the polymerizable compound include compounds described in Paragraph Nos. [0089] to [0098] of JP-A-2008-195018. Preferred examples of the polymerizable compound include esters of an aliphatic polyhydric alcohol compound with an unsaturated carboxylic acid (for example, acrylic acid, methacrylic acid, itaconic acid, crotonic acid, isocrotonic acid or maleic acid). Other preferred polymerizable compounds include polymerizable compounds containing an isocyanuric acid structure described in JP-A-2005-329708.

Of the compounds described above, isocyanuric acid ethylene oxide-modified acrylates, for example, tris(acryloyloxyethyl) isocyanurate or bis(acryloyloxyethyl)hydroxyethyl isocyanurate are particularly preferred, because they are excellent in balance between hydrophilicity relating to the on-press development property and polymerization ability relating to the printing durability.

The amount of the polymerizable compound added is preferably from 5 to 80% by weight, more preferably from 15 to 75% by weight, based on the total solid content of the image-recording layer.

### (D) Mesoporous silica having color changing compound incorporated therein

The mesoporous silica having a color changing compound incorporated therein (D) which can be used in the invention is characterized by having a structure where the mesoporous silica has a color changing compound incorporated into pore thereof. The expression "the mesoporous silica has a color changing compound incorporated into pore thereof" means a state where the color changing compound is present in the pore of mesoporous silica. It is believed that some physical or chemical function (for example, formation of hydrogen bond or capillary force) may exist between the surface of pore of mesoporous silica and the color changing compound. The state where the color changing compound adsorbs on the surface of pore of mesoporous silica is one of preferred embodiments.

### <Mesoporous silica>

The mesoporous silica is a material which is made of silicon dioxide (silica) and has uniform and regular pores (mesopores) and its use for a catalyst, an adsorbent or the like is known. The term "mesopore" is expression on the size of pore in the physical engineering field and means a pore having a diameter of 2 to 50 nm according to IUPAC.

The mesoporous silica which can be used in the invention is not particularly restricted and, for example, known mesoporous silica can be appropriately used. Specifically, the mesoporous silica may be produced according to known methods or commercially available products may be used. The methods for production thereof including methods for controlling pores are described in detail, for example, in Science, 273, No. 5276, 1996, pp. 768-771, Supramolecular Sci., 5, No. 3-4, 1998, pp. 253-259, JP-A-2006-248832, JP-A-2009-107863 and Chem. Mater., 14, 2002, pp. 4721-4728, and these methods may be appropriately employed. For instance, it can be produced by a sol gel method using a surfactant as a mold, and the size of pore, shape of pore and packing structure can be controlled by changing the kind and amount of the surfactant used. In the case where the pore is formed using a surfactant as a mold, for example, a micelle is utilized as the mold. Also, by controlling an alkyl chain length of the surfactant, the diameter of mold is varied to regulate the diameter of pore formed. Further, by adding a relatively hydrophobic molecule, for example, trimethylbenzene or tripropylbenzene together with the surfactant, the micelle expands to make the formation of pore having a larger diameter possible. By utilizing these methods, the pore having an optimum diameter for the color changing compound to be incorporated can be formed.

The mesoporous silica which can be used in the invention may be modified on the surface thereof. Surface modification methods of the mesoporous silica are described, for example, in JP-A-2009-190909. The surface of mesoporous silica which can be used in the invention is inherently hydrophilic, but in order to be stably dispersed in the image-recording layer, the mesoporous silica may be subjected to surface modification with a hydrophilic group.

The surface modification with a hydrophilic group includes a method of chemical modification of a silanol group present on the surface of mesoporous silica with a hydrophilic functional group. As a reagent for the chemical modification, a well-known chemical modification agent, for example, a silane coupling agent, a titanium coupling agent, a zirconia coupling agent, an aluminum coupling agent, a chromium coupling agent, a zirco-aluminum coupling agent or an alcohol may be used. In particular, a silane coupling agent and an organic silicone compound referred to as a silylation agent or the like are exemplified.

Specific examples thereof include an epoxysilane, for example, γ-glycidoxypropyltriethoxysilane or β-(3,4-epoxycyclohexyl)ethyltrimethoxysilane, an aminosilane, for example, aminopropyltriethoxysilane, ureidopropyltriethoxysilane or N-phenylaminopropyltrimethoxysilane, 3-carboxypropylsilane and 3-mercaptopropylsilane.

In addition, hexamethyldisilazane, trimethylchlorosilane, N-methyl-N-trimethylsilylacetamide, N-trimethylsilyldisilanamine, N-trimethylsilyldimethylamine, N-methyl-N-trimethylsilyltrifluoroacetamide, N,O-bis(trimethylsilyl)acetamide, N,O-bis(trimethylsilyl)trifluoroacetamide, N-trimethylsilylimidazole or the like may be used.

The chemical modification of a silanol group present on the surface of mesoporous silica with a hydrophilic functional group by a chemical modification agent may be conducted according to a conventional method ordinarily used as to each chemical modification agent. For example, in case of a silane coupling agent, a solution is prepared by hydrolyzing the coupling agent by adding water, adding an alcohol and a catalyst, for example, acetic acid thereto and dissolving in a solvent, and mesoporous silica is immersed in the resulting solution thereby conducting the surface treatment.

The pore size of the mesoporous silica which can be used in the invention is preferably from 2 to 25 nm, and more preferably from 4 to 10 nm. When the pore size is too small, it is difficult for the color changing compound to adsorb in a sufficient amount in the pore, whereas when the pore size is too large, it is believed that due to the increase in pore size a rate of surface area in the inside of the pore reduces thereby decreasing the adsorption amount of color changing compound.

The mesoporous silica which can be used in the invention is preferably particulate. The particle size of the mesoporous silica is ordinarily from 50 to 500 nm, preferably from 50 to 300 nm, and more preferably from 100 to 300 nm. When the particle size is too small, a number of particles per unit area relatively increases to result in deterioration of printing durability based on decrease in film strength of the image-recording layer, whereas when the particle size is too large, it is believed that dispersibility of the mesoporous silica particle decreases and as a result, the image strength in the image-recording layer decreases to result in deterioration of printing durability.

### <Color changing compound>

The color changing compound which is incorporated into mesoporous silica is a compound which changes color upon a physical or chemical function. It includes, for example, a compound which changes color due to light, an acid, heat or the like. The color changing compound per se may be a colored compound or a colorless compound.

### (1) Color changing compound which changes color due to light

Examples of the color changing compound which changes color due to light (hereinafter, also referred to as a photo-color changing compound) include a cyanine dye. The cyanine dye preferred for the photo-color changing compound includes the cyanine dye represented by formula (1) described above.

As more preferred example of the photo-color changing compound, a cyanine dye represented by formula (2) shown below is exemplified.

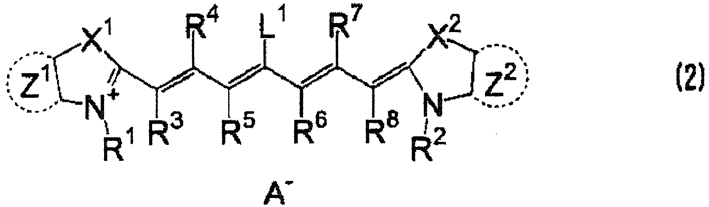

In formula (2), L¹ represents a hydrogen atom, a halogen atom, -NPh₂ or -Y³-L². Y³ represents an oxygen atom, a nitrogen atom or a sulfur atom. L² represents an alkyl group, an aryl group, a heteroaromatic ring group or a hydrocarbon group having from 1 to 12 carbon atoms and containing a hetero atom. The hetero atom in the heteroaromatic ring group or hydrocarbon group having from 1 to 12 carbon atoms and containing a hetero atom represents a nitrogen atom, a sulfur atom or an oxygen atom.

X¹ and X² each independently represents a sulfur atom, an oxygen atom or a dialkylmethylene group having 12 or less carbon atoms. Z¹ and Z² each independently represents an aromatic ring or a heteroaromatic ring.

R¹ and R² each independently represents a hydrocarbon group. R³, R⁴, R⁷ and R⁸ each independently represents a hydrogen atom or a hydrocarbon group having 12 or less carbon atoms. R⁵ and R⁶ each independently represents a hydrocarbon group, or R⁵ and R⁶ may be combined with each other to form a 5-membered or 6-membered ring. A⁻ represents a counter anion.

Each of the substituents and ring structures described above may have a substituent, and examples of the substituent capable of being introduced include an alkyl group having from 1 to 12 carbon atoms, an aryl group having from 6 to 12 carbon atoms, a halogen atom, an alkoxy group having from 1 to 12 carbon atoms, an aryloxy group having from 6 to 12 carbon atoms, a hydroxy group, an amino group, a carbonyl group, a carboxyl group, a sulfo group and a silyl group.

The counter anion represented by A⁻ has the same meaning as Za- defined in formula (1) above, and preferred examples thereof are also the same.

As a still more preferred example of the photo-color changing compound, a cyanine dye represented by formula (3) shown below is exemplified.

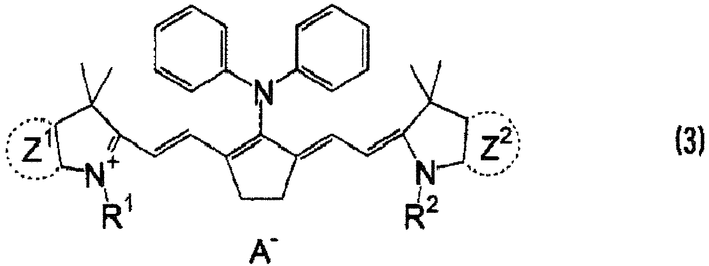

In formula (3), Z¹ and Z² each independently represents an aromatic ring or a heteroaromatic ring. R¹ and R² each independently represents a hydrocarbon group. A⁻ represents a counter anion.

Each of the substituents and ring structures described above may have a substituent, and examples of the substituent capable of being introduced include an alkyl group having from 1 to 12 carbon atoms, an aryl group having from 6 to 12 carbon atoms, a halogen atom, an alkoxy group having from 1 to 12 carbon atoms, an aryloxy group having from 6 to 12 carbon atoms, a hydroxy group, an amino group, a carbonyl group, a carboxyl group, a sulfo group and a silyl group.

The counter anion represented by A⁻ has the same meaning as Za- defined in formula (1) above, and preferred examples thereof are also the same.

In the case where the cyanine dye is used as the color changing compound, an onium salt may be used, if desired, as a compound which assists the color change of the cyanine dye (hereinafter, also referred to as a color changing aid for cyanine dye). The onium salt is preferably incorporated into the pore of mesoporous silica together with the cyanine dye.

The onium salt used as the color changing aid for cyanine dye is preferably a compound represented by any one of formulae (4) to (6) shown below. Of the compounds represented by formula (4) to (6), a sulfonium salt represented by formulae (4) and an iodonium salt represented by formula (6) are more preferred.

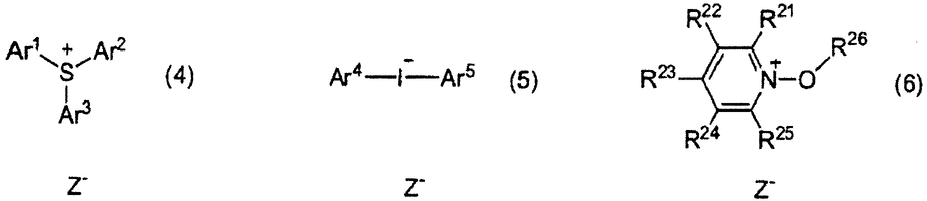

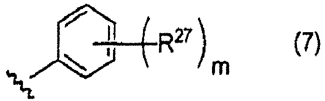

In formulae (4) to (6), Ar¹, Ar², Ar³, Ar⁴ and Ar⁵ each independently represents a group represented by formula (7). R²¹, R²², R²³, R²⁴ and R²⁵ each independently represents a hydrogen atom, an alkyl group, an alkoxy group, an aryl group, a cyano group or a halogen atom, or R²¹ and R²² or R²² and R²³ may be combined with each other to form a condensed ring structure. R²⁶ represents an alkyl group or an aryl group. Z⁻ represents an anion.

In formula (7), R²⁷ represents an alkyl group, an alkoxy group or a halogen atom, and plural R²⁷s may be the same or different. m represents an integer from 0 to 5.

In formula (4), Ar¹, Ar² and Ar³ each preferably represents a group represented by formula (10) shown below. In formula (5), Ar⁴ and Ar⁵ each preferably represents a group represented by formula (11) shown below.

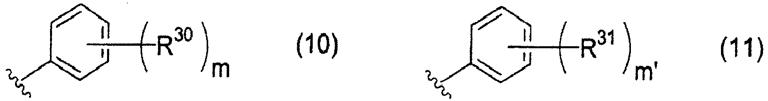

In formulae (10) and (11), R³⁰ represents a halogen atom, and plural R³⁰s may be the same or different. R³¹ represents an alkyl group or an alkoxy group, and plural R³¹s may be the same or different. m and m' each represents an integer from 0 to 5.

The alkyl group represented by any of R²¹, R²², R²³, R²⁴, R²⁵, R²⁶, R²⁷ and R³¹ is preferably an alkyl group having from 1 to 20 carbon atoms, more preferably an alkyl group having from 1 to 10 carbon atoms, and particularly preferably an alkyl group having from 1 to 4 carbon atoms.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, 1-methylbutyl group, an isohexyl group, a 2-ethylhexyl group, a 2-methylhexyl group, a cyclohexyl group, a cyclopentyl group and a 2-norbornyl group.

Of the alkyl groups, a methyl group, an ethyl group, a propyl group, a butyl group and a tert-butyl group are particularly preferred.

In the case where any of R²¹, R²², R²³, R²⁴, R²⁵, R²⁷ and R³¹ represents an alkoxy group, a preferred embodiment of an alkyl group included in the alkoxy group is same as the preferred embodiment of the alkyl group in the case where any of R²¹, R²², R²³, R²⁴, R²⁵, R²⁶, R²⁷ and R³¹ represents the alkyl group.

The aryl group represented by any of R²¹, R²², R²³, R²⁴, R²⁵ and R²⁶ is preferably an aryl group having from 6 to 30 carbon atoms, more preferably an aryl group having from 6 to 20 carbon atoms, and particularly preferably an aryl group having from 6 to 12 carbon atoms.

Specific examples of the aryl group include a phenyl group, a biphenyl group, a 1-naphthyl group, a 2-naphthyl group, a 9-fluorenyl group, a terphenyl group, an o-, m- or p-tolyl group, a xylyl group, an o-, m- or p-cumenyl group, a mesityl group, a biphenylenyl group, an indacenyl group, a fluorenyl group, a p-chlorophenyl group, a p-bromophenyl group, a p-fluorophenyl group, an o-chlorophenyl group, an o-bromophenyl group, an o-fluorophenyl group, a p-methoxyphenyl group, a m-methoxyphenyl group, a p-dimethylaminophenyl group, a p-methylthiophenyl group, a m-methylthiophenyl group, p-phenyltiophenyl group, a 2,3-difluorophenyl group, a 2,3-dichlorophenyl group, a 2,4-difluorophenyl group, a 2,4-dichlorophenyl group, a 2,5-difluorophenyl group, a 2,5-dichlorophenyl group, a 2,6-difluorophenyl group, a 2,6-dichlorophenyl group, a 2,4,6-trifluorophenyl group, a 2,4,6-trichlorophenyl group, a 3,4,5-trifluorophenyl group and a 3,4,5-trichlorophenyl group.

Of the aryl groups, a phenyl group, a p-methoxyphenyl group and a p-dimethylaminophenyl group are particularly preferred.

The anion represented by Z⁻ includes a halide ion, a perchlorate ion, a tetrafluoroborate ion, a hexafluorophosphate ion and a sulfonate ion, and is preferably a perchlorate ion, a hexafluorophosphate ion and an arylsulfonate ion and particularly preferably a hexafluorophosphate ion.

Specific examples of the onium salt used as the color changing aid for cyanine dye are set forth below, but the invention should not be construed as being limited thereto.

Examples of the compound (sulfonium salt) represented by formula (4) include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate, tris(4-chlorophenyl)sulfonium hexafluorophosphate, tris(2,4-dichlorophenyl)sulfonium hexafluorophosphate, bis(2,4-dichlorophenyl)phenylsulfonium hexafluorophosphate and bis(2,4-dichlorophenyl)-4-methoxyphenylsulfonium hexafluorophosphate.

Examples of the compound (iodonium salt) represented by formula (5) include diphenyliodonium hexafluorophosphate, 4-methoxyphenyl-4-(2-methylpropyl)phenyliodonium hexafluorophosphate, 4-chlorophenyl-4-phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium hexafluorophosphate.

Examples of the compound (azinium salt) represented by formula (6) include 1-cyclohexylmethyloxypyridinium hexafluorophosphate, 1-cyclohexyloxy-4-phenylpyridinium hexafluorophosphate, 1-methoxypyridinium hexafluorophosphate, 1-methoxy-4-tert-butylpyridinium hexafluorophosphate, 1-methoxy-4-methoxypyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate. (2) Color changing compound which changes color due to acid

As the color changing compound which changes color due to an acid (hereinafter, also referred to as an acid-color changing compound), any compound which causes change in color due to an acid may be suitably used. Examples of the acid-color changing compound include a triarylmethane compound, a biphenylmethane compound, a xanthene compound, a thiazine compound and compounds represented by formulae (II-1) to (II-3) shown below. Of the compounds, the triarylmethane compound, xanthene compound and compounds represented by formulae (II-1) to (II-3) are preferred, and the compounds represented by formula (II-3) are particularly preferred.

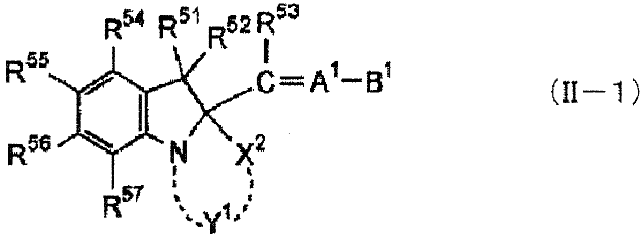

In formula (II-1), X² represents N(R⁵⁸), O or S, Y¹ represents an atomic group necessary for forming a cyclic structure together with N-C-X², A¹ represents C(R⁵⁹) or N, R⁵¹ to R⁵⁹, which may be the same or different, each represents a hydrogen atom or a substituent, or R⁵⁴, R⁵⁵, R⁵⁶ and R⁵⁷ may be combined with each other to form a condensed ring, and B¹ represents an aryl group, a heterocyclic group, an alkenyl group, an alkynyl group, an arylamino group or a heterocyclic amino group.

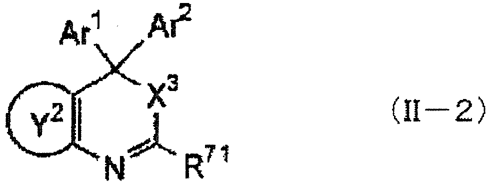

In formula (II-2), Ar¹ and Ar², which may be the same or different, each represents an aryl group, a heterocyclic group, an alkenyl group or an alkynyl group, R⁷¹ represents a hydrogen atom or a substituent, Y² represents an aromatic hydrocarbon ring or a heterocyclic ring, X³ represents O, S or N(R⁷²), and R⁷² represents a hydrogen atom or a substituent.

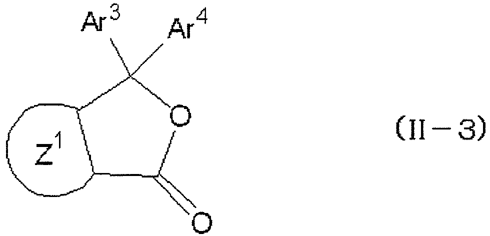

In formula (II-3), Ar³ and Ar⁴, which may be the same or different, each represents an aryl group, a heterocyclic group, an alkenyl group or an alkynyl group, and Z¹ represents an aromatic hydrocarbon ring or a heterocyclic ring.

In the leuco dye represented by formula (II-1), R⁵¹ to R⁵⁷ each independently represents a hydrogen atom, an alkyl group (for example, a methyl group, an ethyl group, an n-propyl group, an isopropyl group, a tert-butyl group, a n-octyl group, a dodecyl group, a cyclopropyl group, a cyclopentyl group, a cyclohexyl group, a [0,1,3]bicyclohexyl group, a [1,2,2]bicycloheptyl group or a [1,1,3]bicycloheptyl group), an aryl group (for example, a phenyl group or a naphthyl group), or a heterocyclic group (for example, a furyl group, a thienyl group, a pyrimidinyl group or a bonzothiazolyl group). The number of carbon atoms in each of these groups is preferably from 1 to 18, and more preferably from 1 to 12. Each of R⁵¹ to R⁵⁷ is preferably an alkyl group or an aryl group, and particularly preferably an aryl group. As to R⁵⁴, R⁵⁵, R⁵⁶ and R⁵⁷, in the case where the adjacent two groups thereof are connected with each other to form a condensed ring, examples of the condensed ring include a naphthalene ring, an anthracene ring, a benzofuran ring and a benzothiophene ring.

These groups may have a substituent and as the substituent, any substituent capable of substituting may be used. Examples of the preferred substituent include a halogen atom, an alkyl group, an alkenyl group, an alkynyl group, an aryl group, a heterocyclic group, a cyano group, a hydroxy group, a nitro group, a carboxyl group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group, an acylamino group, a carbamylamino group, an alkoxycarbonylamino group, an aryloxycarbonylamino group, a sulfamoylamino group, an alkylsulfonylamino group, an arylsulfonylamino group, a mercapto group, an alkylthio group, an arylthio group, a heterocyclic thio group, a sulfamoyl group, a sulfo group, an alkylsulfinyl group, an arylsulfinyl group, an alkylsulfonyl group, an arylsulfonyl group, an acyl group, an aryloxycarbonyl group, an alkoxycarbonyl group, a carbamoyl group, an imido group, a phosphino group, a phosphinyl group, a phosphinyloxy group, a phosphinylamino group and a silyl group.

In formula (II-1), each of R⁵¹ and R⁵² is preferably an alkyl group.

In formula (II-1), when X² represents N(R⁵⁸) and R⁵⁸ represents a substituent, the substituent represented by R⁵⁸ includes the substituents described in the case where each of R⁵¹ to R⁵⁷ represents the substituent. X² is particularly preferably O.

In formula (II-1), when Y¹ represents an atomic group necessary for forming a cyclic structure together with N-C-X², Y¹ is preferably an atomic group necessary for forming a 5-membered or 6-membered ring. Examples of the atom constituting Y¹ necessary for forming the ring skeleton include a carbon atom, a nitrogen atom, a sulfur atom, a silicon atom and a phosphorus atom. These atoms may have a hydrogen atom or a substituent, if desired, and when plural substituents are present, the substituents may be the same or different or may be combined with each other to form a ring.

In the case where the atom constituting Y¹ has a substituent, examples of the substituent include =O (forming a carbonyl group, a sulfonyl group or the like together with the skeleton atom of Y¹), =S (forming a thiocarbonyl group or the like together with the skeleton atom of Y¹), =N-R⁶⁰ (R⁶⁰ represents a hydrogen atom or a substituent, and examples of the substituent include the substituents described in the case where each of R⁵¹ to R⁵⁷ represents the substituent), and the substituents described in the case where each of R⁵¹ to R⁵⁷ represents the substituent.

A preferred embodiment of Y¹ is a divalent connecting group formed by connecting a divalent group represented by -C(R⁶¹)(R⁶²)- or -C(=O)- in an appropriate combination (wherein R⁶¹ and R⁶², which may be the same or different, each represents a hydrogen atom or a substituent, or plural R⁶¹ and R⁶² present in the molecule may be combined with each other to form a ring, and examples of the substituent represented by each of R⁶¹ and R⁶² include the substituents described in the case where each of R⁵¹ to R⁵⁷ represents the substituent). Specific examples of Y¹ include -CH₂CH₂-, -CH₂CH₂CH₂-, -CH(CH₃)CH₂-, -CH₂C(=O)-, -C(=O)CH₂-, -CH₂CH₂C(=O)-, -C(=O)CH₂CH₂- and -CH=CH-. A preferred embodiment of Y¹ is -[C(R⁶¹)(R⁶²)]₂-.

In formula (II-1), when A¹ represents C(R⁵⁹) and R⁵⁹ represents a substituent, examples of the substituent include the substituents described in the case where each of R⁵¹ to R⁵⁷ represents the substituent. A particularly preferred example of A¹ is CH.

B¹ represents an aryl group (for example, a phenyl group or a naphthyl group), a heterocyclic group (for example, a furyl group, a thienyl group, a pyrimidinyl group or a bonzothiazolyl group), an alkenyl group (for example, a vinyl group, an allyl group, a prenyl group, a geranyl group, an oleyl group or a 2-cyclopenten-1-yl group), an alkynyl group (for example, an ethynyl group, a propargyl group or a trimethylsilylethynyl group), an arylamino group or a heterocyclic amino group. These groups may have a substituent at a position capable of being substituted, and examples of the substituent include the substituents described in the case where each of R⁵¹ to R⁵⁷ represents the substituent. Also, as to the substituent, two different groups may be combined with each other to form a condensed ring or the substituent may form a ring together with R⁵⁹. B¹ is preferably an aryl group or a heterocyclic group.

Of the compounds represented by formula (II-1), a compound represented by formula (II-4) shown below is preferred.

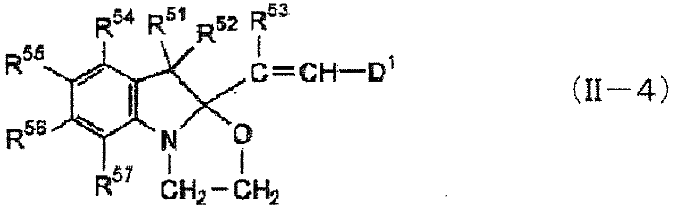

In formula (II-4), R⁵¹ to R⁵⁷ have the same meanings as defined in formula (II-1), and D¹ represents an aryl group (for example, a phenyl group or a naphthyl group) or a heterocyclic group (for example, a furyl group, a thienyl group, a pyrimidinyl group or a bonzothiazolyl group).

In the case where the aryl group or heterocyclic group represented by D¹ has a substituent, examples of the substituent include the substituents described in the case where each of R⁵¹ to R⁵⁷ represents the substituent.

In the leuco dye represented by formula (II-2), when R⁷¹ represents a substituent, examples of the substituent include the substituents described in the case where each of R⁵¹ to R⁵⁷ represents the substituent. Of the substituents, an alkyl group, an aryl group, a heterocyclic group, an alkoxy group, an aryloxy group, a silyloxy group, a heterocyclic oxy group, a carbamoyloxy group, an alkoxycarbonyloxy group, an aryloxycarbonyloxy group, an amino group (including an aniline group), an acylamino group, an aminocarbonylamino group, an alkoxycarbonylamino group, an aryloxycarbonylamino group, an alkylthio group, an arylthio group, a heterocyclic thio group and a silyl group are preferred, and an alkyl group, an aryl group, a heterocyclic group, an alkoxy group, an aryloxy group, a heterocyclic oxy group, an amino group (including an aniline group), an acylamino group, an aminocarbonylamino group, an alkoxycarbonylamino group and an aryloxycarbonylamino group are particularly preferred. Of the substituents, when the substituent has a hydrogen atom, the hydrogen atom is eliminated and substituted with the substituent described above.

In formula (II-2), Ar¹ and Ar², which may be the same or different, each represents an aryl group (for example, a phenyl group or a naphthyl group), a heterocyclic group (for example, a furyl group, a thienyl group, a pyrimidinyl group or a bonzothiazolyl group), an alkenyl group (for example, a vinyl group, an allyl group, a prenyl group, a geranyl group, an oleyl group or a 2-cyclopenten-1-yl group) and an alkynyl group (for example, an ethynyl group, a propargyl group or a trimethylsilylethynyl group). These groups may have a substituent at a position capable of being substituted, and examples of the substituent include the substituents described in the case where each of R⁵¹ to R⁵⁷ represents the substituent.

When Ar¹ and Ar² have plural substituents, the substituents may be connected with each other to form a condensed ring or Ar¹ and Ar² may be connected with each other to from a ring. Examples of the condensed ring formed by the substituents introduced into Ar¹ or the substituents introduced into Ar² include a julolidine ring, a naphthalene ring, an anthracene ring, a benzofuran ring and a benzothiophene ring. Examples of the ring formed by connecting Ar¹ and Ar² include a 9H-xanthene ring, a 10-alkyl-9,10-dihydroacridine ring, a 9H-thioxanthene ring, a 1-alkyl-4H-chromeno[2,3-C]pyrazole ring, a 11H-benzo[b]thieno[3,2-b]chromene ring, a 6-alkyl-5-oxo-5,6-dihydro-12H-chromeno[2,3-C]isoquinoline ring, a 4H-chromene ring, a 2H-chromene ring and a fluorene ring.

Each of Ar¹ and Ar² is preferably an aryl group or a heterocyclic group. The cases where at least one of Ar¹ and Ar² is an electron donating aryl group (for example, a p-dimethylaminophenyl group, a p-julolidinyl group or a p-methoxyphenyl group) or a heterocyclic group selected from a 1,2,3,4-tetrahydroquinolin-6-yl group, a 3,3-dimethylindolin-5-yl group, a 3,4-methylenedioxyphenyl group, a 1,2-dimethyl-5-benzimidazolyl group, a 10-ethylphenothiazin-3-yl group, a 9-ethylcarbazol-3-yl group, a dibenzofuran-3-yl group, a dibenzothiophen-3-yl group, a quinolin-8-yl group, a 1,2-dimethylindol-3-yl group, an ethylindazol-3-yl, a benzo[b]furan-3-yl group, a benzo[b]thiophen-3-yl group, a 1-ethylpyrrol-3-yl group, a 3-furyl group, a 3-thienyl group, a 2-thiazolyl group, a 2-benzoxazolyl group, a 2-pyridyl group and a 4-quinolyl group, and the cases where at least one of Ar¹ and Ar² has an electron donating group as the substituent and Ar¹ and Ar² are connected with each other to form the condensed ring described above are particularly preferred.

Y² represents an aromatic hydrocarbon ring (for example, a benzene ring, a naphthalene ring or an anthracene ring) or a heterocyclic ring (for example, a pyridine ring, a pyrimidine ring, an indole ring, a furan ring or a thiazine ring). These rings may be substituted with a substituent at a position capable of being substituted. Examples of the substituent include the substituents described in the case where each of R⁵¹ to R⁵⁷ represents the substituent. Y² is preferably an aromatic hydrocarbon ring, and particularly preferably a benzene ring.

When X³ represents N(R⁷²) and R⁷² represents a substituent, the substituent represented by R⁷² includes the substituents described in the case where R⁷¹ represents the substituent. X³ is preferably O or S.

The compound represented by formula (II-2) can be synthesized, for example, by acting an acid halide or isocyanate to a triarylmethane derivative having an amino group at an ortho position synthesized from a Michler's hydrol and an arylamine, and then being oxidized using an oxidant, for example, lead dioxide, manganese dioxide or chloranil. The synthesis methods are described in detail, for example, in JP-A-57-47697, JP-A-61-17573 and JP-A-63-251278.

In the compound represented by formula (II-3), the aryl group, heterocyclic group, alkenyl group and alkynyl group represented by any of Ar³ and Ar⁴ have the same meanings as the aryl group, heterocyclic group, alkenyl group and alkynyl group (including these groups having the substituent) represented by any of Ar¹ and Ar² defined in formula (II-2) described above, respectively.

In the compound represented by formula (II-3), Ar³ and Ar⁴ preferably represent a combination of an aryl group and an aryl group, a combination of an aryl group and a heterocyclic group or a combination of an aryl group and an alkenyl group. These groups may have a substituent at a position capable of being substituted. The case where the aryl group having an alkylamino group as the substituent is more preferred.

The hydrocarbon ring and heterocyclic ring represented by Z¹ have the same meanings as the hydrocarbon ring and heterocyclic ring represented by Y² defined in formula (II-2) described above, respectively.

The compound represented by formula (II-3) can be synthesized by the method described in JP-A-58-17036.

Specific examples of the acid-color changing compound are set forth below, but the invention should not be construed as being limited thereto.

Brilliant green, eosin, ethyl violet, erythrosine B, methyl green, crystal violet, basic fuchsin, phenolphthalein, 1,3-diphenyltriazine, alizarin red S, thymolphthalein, methyl violet 2B, quinaldine red, rose bengal, metanil yellow, thymolsulfophthalein, xylenol blue, methyl orange, orange IV, diphenylthiocarbazone, 2,7-dichlorofluorescein, paramethyl red, congo red, benzopurpurine 4B, a-naphthyl red, nile blue 2B, nile blue A, phenacetarin, methyl violet, malachite green, parafuchsin, victoria pure blue BOH, oil blue #603, oil pink #312, oil red 5B, oil scarlet #308, oil red OG, oil red RR, oil green #502, spiron red BEH special, m-cresol purple, cresol red, rhodamine B, rhodamine 6G, fast acid violet R, sulforhodamine B, auramine, 4-p-diethylaminophenyliminonaphthoquinone, 2-carboxyanilino-4-p-diethylaminophenyliminonaphthoquinone, 2-carbostearylamino-4-p-dihydroxyethylaminophenyliminonapthoquinone, p-methoxybenzoyl-p'-diethylamino-o'-methylphenyliminoacetanilide, cyano-p-diethylaminophenyliminoacetanilide, 1-phenyl-3-methyl-4-p-diethylaminophenylimino-5-pyrazolone, 1-β-napthyl-4-p-diethylaminophenylimino-5-pyrazolone, pentamethoxy red and heptamethoxy red are exemplified.

Also, a triphenylmethanephthalide compound, for example, 3,3-bis(p-dimethylaminophenyl)phthalide, 3,3-bis(p-dimethylaminophenyl)-6-dimethylaminophthalide, 4-hydroxy-4'-dimethylaminotriphenylmethane lactone, 4,4'-bisdihydroxy-3,3'-bisdiaminotriphenylmethane lactone or crystal violet lactone; an indolylphthalide compound, for example, 3-(4-diethylamino-2-ethoxyphenyl)-3-(1-ethyl-2-methylindol-3-yl)-4-azaphthali de, 3-(4-diethylaminophenyl)-3-(1-ethyl-2-methylindol-3-yl)phthalide, 3,3-bis(1-n-butyl-2-methylindol-3-yl)phthalide or 3,3-bis(1-ethyl-2-methylindol-3-yl)phthalide; a fluoran compound, for example, 3-diethylamino-6-methyl-7-anilinofluoran, 3-dibutylamino-6-methyl-7-anilinofluoran, 3-diethylamino-6-methyl-7-xylidinofluoran, 3-dibutylamino-6-methyl-7-xylidinofluoran, 3-diethylamino-7-chloroanilinofluoran, 3-diethylamino-7,8-benzofluoran, 3,6-dimethoxyfluoran, 3-diethylamino-6-methoxy-7-aminofluoran, 3-diethylamino-7-benzylaminofluoran, 3-diethylamino-6-methylchlorofluoran, 3-dimethylamino-6-methoxyfluoran, 3,6-bis-β-methoxyethoxyfluoran, 3-diethylamino-6-methyl-7-chlorofluoran, 3,7-bisdiethylaminofluoran or 3-diethylamino-7-methoxyfluoran are exemplified.

Further, the compounds shown below are exemplified.

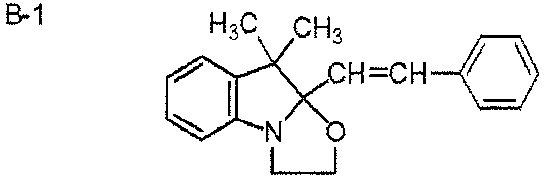

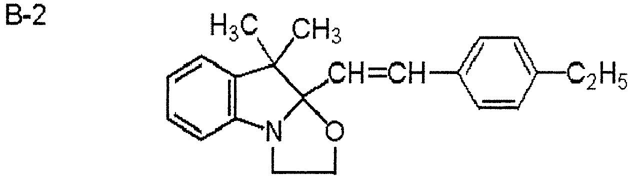

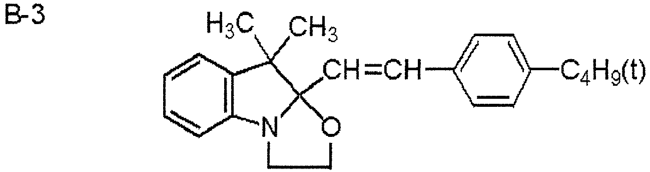

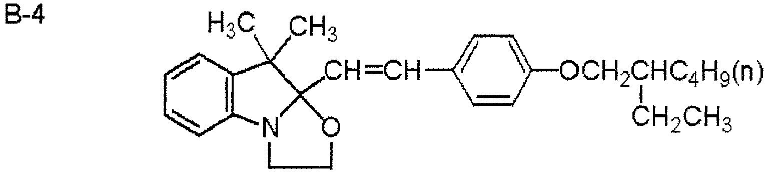

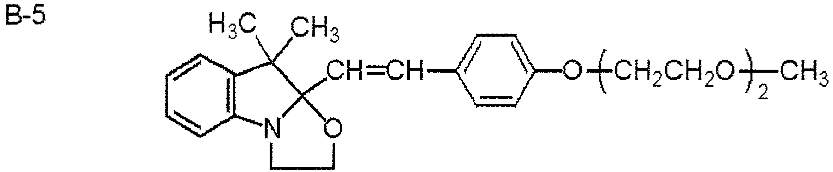

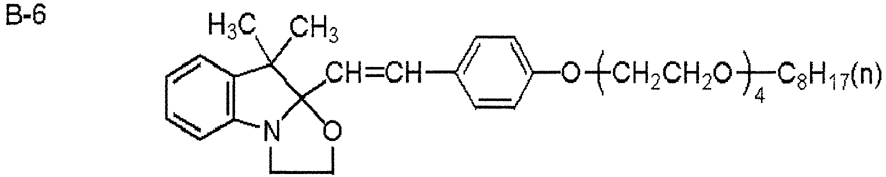

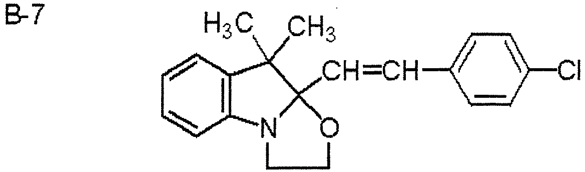

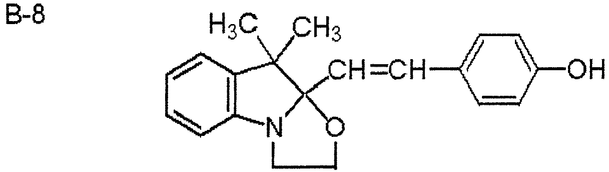

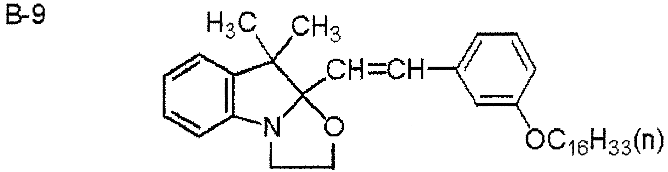

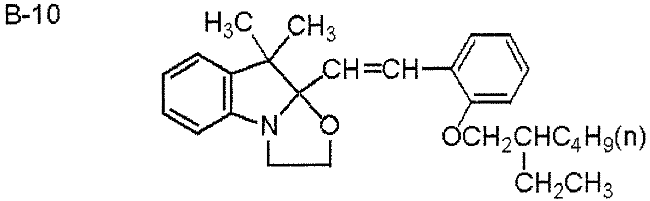

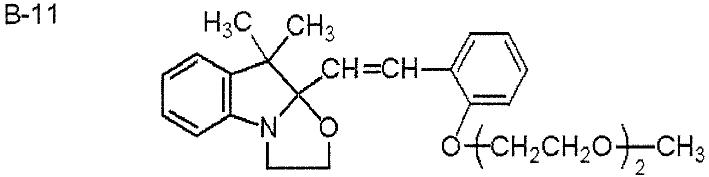

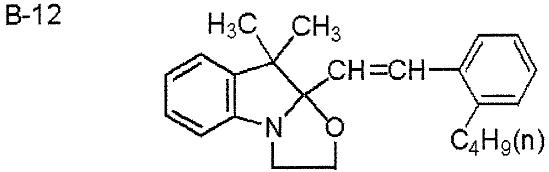

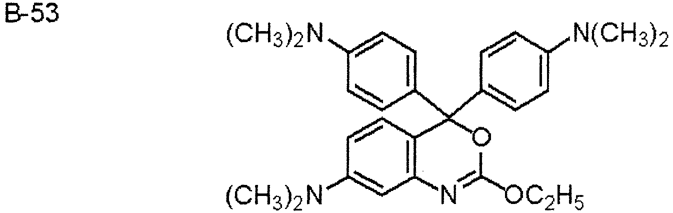

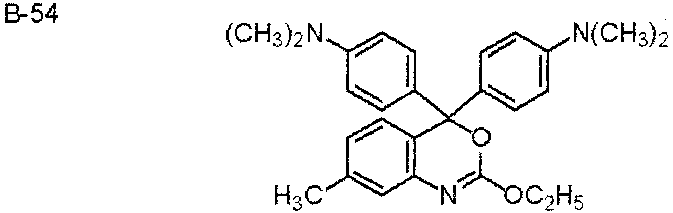

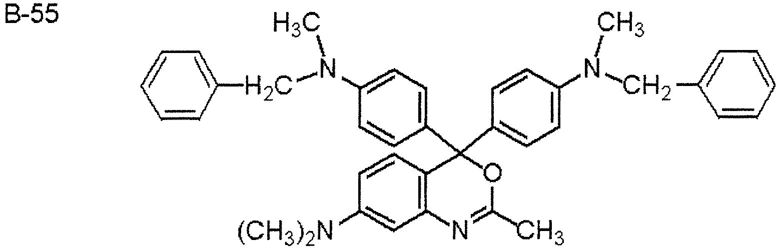

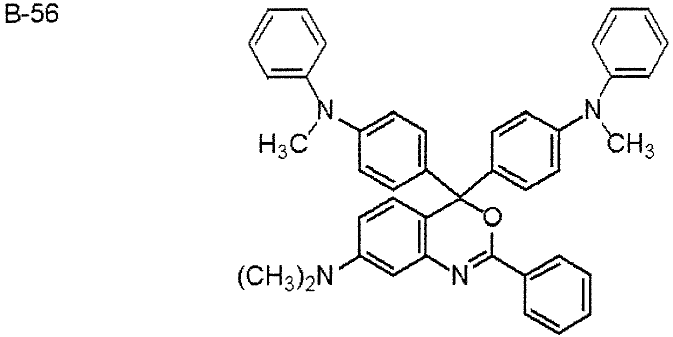

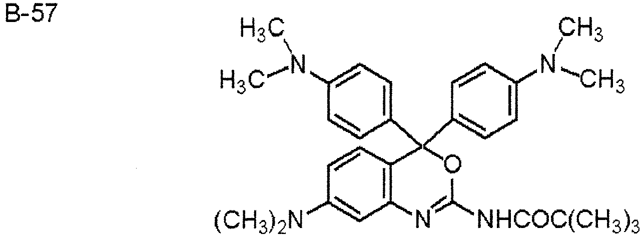

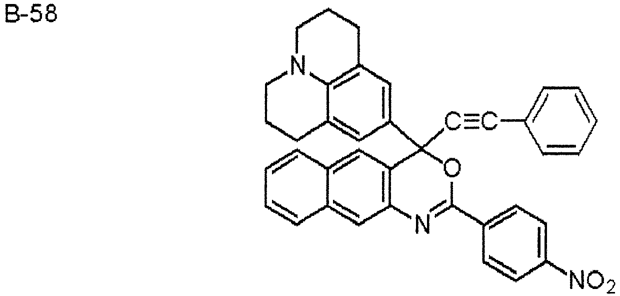

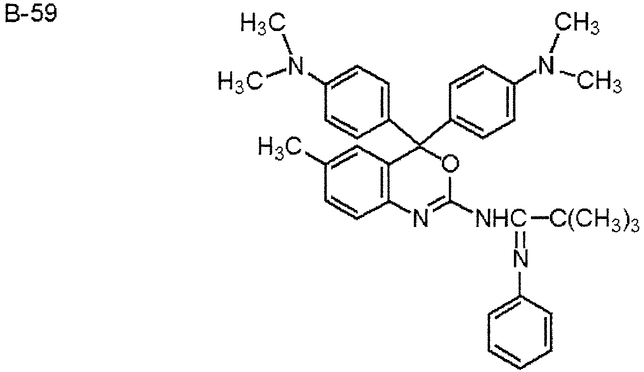

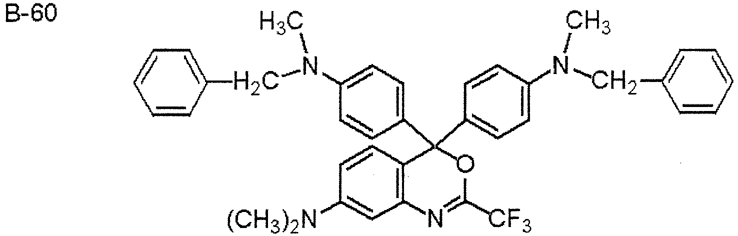

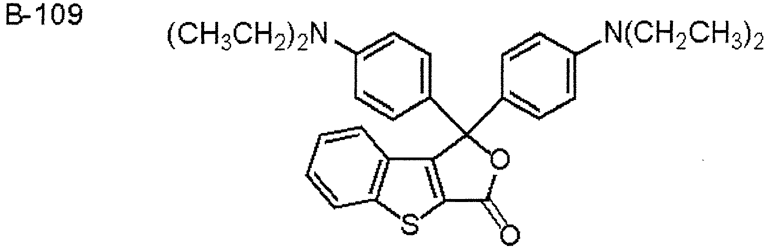

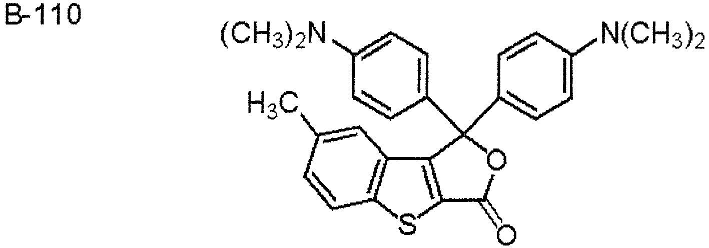

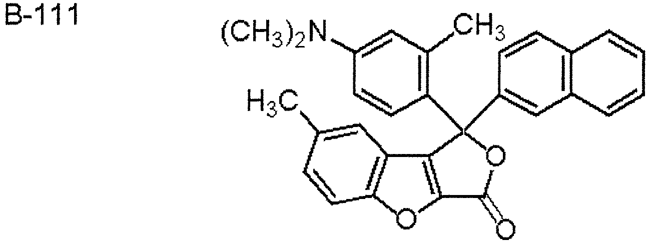

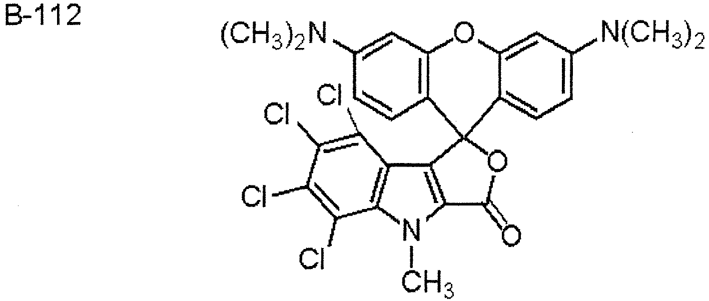

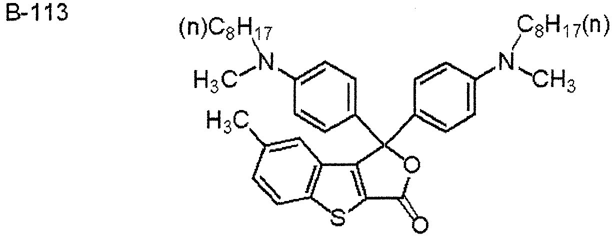

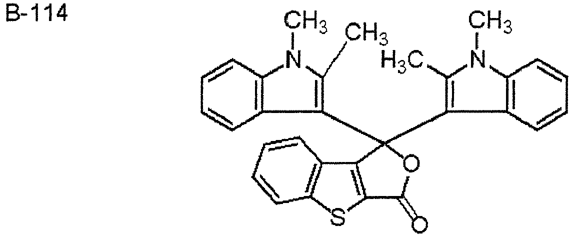

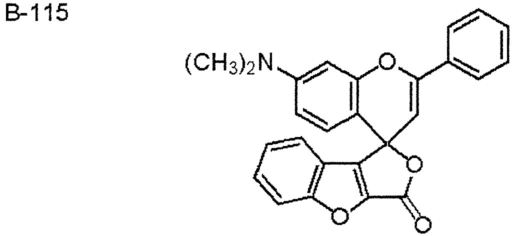

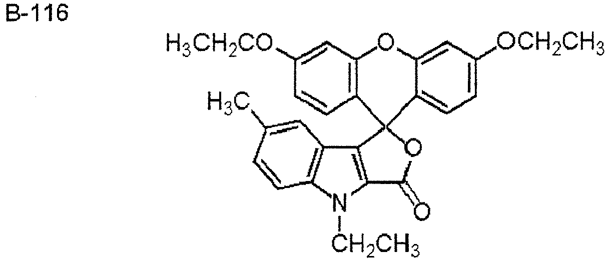

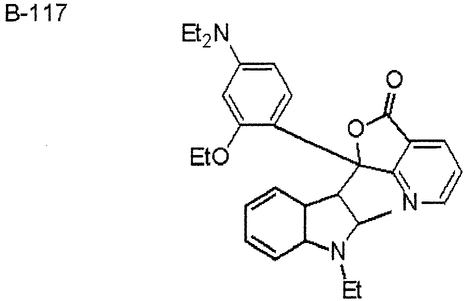

### (3) Color changing compound which changes color due to heat

As the color changing compound which changes color due to heat (hereinafter, also referred to as an heat-color changing compound), any known compound which causes change in color due to heat may be used without particular restriction. Examples thereof are described, for example, in Kinousei Shikiso (Functional dyes), CMC publishing Co., Ltd. (1986), Chromic Zairyo to Oyo (Chromic Materials and applications), CMC publishing Co., Ltd. (1989), Photochromism, Wiley-Interscience (New York) (1971), and Organic Photochromic and Thermochromic Compounds, Kluwer Academic/Plenum Publishers (New York) (1999).

As the heat-color changing compound, for instance, a spiro compound, a condensed aromatic ring-substituted ethylene derivative, for example, an anthrone, a polythiophene derivative, a liquid crystal, for example, a cholesteric liquid crystal, and METHAMOCOLOR (registered trademark, produced by The Pilot Pen Co., Ltd.), which is a material causing color change upon heat based on an electron donating and accepting mechanism at a thermal equilibrium of a polar compound of electron donor and electron acceptor, may be used.

Further, a dye which changes color upon heat described in JP-A-6-340821, a spirooxazine compound described in JP-A-7-165762 or the like may be also used.

The spiro compound is particularly preferred.

Of the spiro compounds, a compound represented by formula (IB) shown below is preferred.

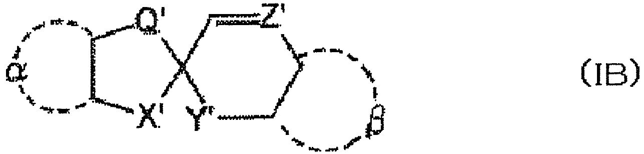

In formula (IB), X' represents NR¹, O or S. R¹ represents an alkyl group having from 1 to 20 carbon atoms, which may be substituted, an alkenyl group having from 2 to 20 carbon atoms, which may be substituted, an alkynyl group having from 2 to 20 carbon atoms, which may be substituted, an aralkyl group having from 7 to 20 carbon atoms which may be substituted, or an aryl group having from 6 to 19 carbon atoms which may be substituted. α and β each represents an atomic group which forms a ring together with the carbon atoms connected, and specifically represents a divalent connecting group selected from a divalent connecting group formed by eliminating one hydrogen atom from the above-described alkyl group, alkenyl group, alkynyl group, aryl group or heteroaryl group, a connecting group containing a hetero atom and having a partial structure, for example, as shown below and a connecting group formed by combination of two or more of these connecting groups. Each of α and β is preferably an atomic group which forms an aryl ring (for example, a benzene ring or a naphthalene ring).

Q' represents O, S or CR²R³. When Q' represents CR²R³, R² and R³ each independently represents an alkyl group having from 1 to 20 carbon atoms, an alkenyl group having from 2 to 20 carbon atoms, an alkynyl group having from 2 to 20 carbon atoms, an aralkyl group having from 7 to 20 carbon atoms or an aryl group having from 6 to 19 carbon atoms, or R² and R³ may be combined with each other to from a ring having from 3 to 20 carbon atoms.

Y' represents N, O or S. Z' represents CH or N.

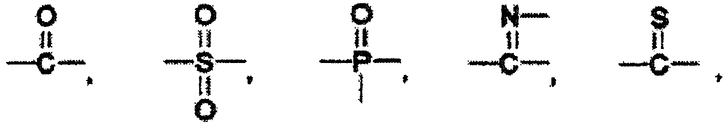

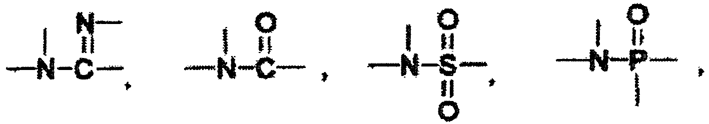

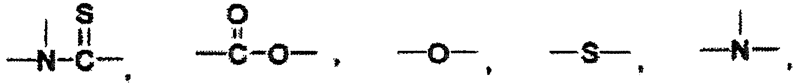

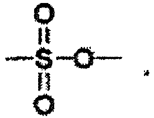

Specific examples of the spiropyran preferably used in the invention include a benzospiropyran compound, for example, 1,3,3-trimethylindolino-8'-methoxybenzopyrilospiran, 1,3,3-trimethylindolino-6'-nitrobenzopyrilospiran, 1,3,3-trimethylindolino-6'-nitro-8'-methoxybenzopyrilospiran, 1,3,3-trimethylindolino-5-methoxy-6'-nitrobenzopyrilospiran, 1,3,3-trimethylindolino-6'-bromo-8'-nitrobenzopyrilospiran or 1,3,3-trimethylindolinobenzopyrilospiran, a naphthospiropyran compound, for example, 1,3,3-trimethylindolino-7'-nitronaphthopyrilospiran, 1,3,3-trimethylindolino-8'-nitronaphthopyrilospiran or 1,3,3-trimethylindolinonaphthopyrilospiran, and 1,3,3-trimethylindolinobenzospirothiopyran.

Specific examples of the spirooxazine preferably used in the invention include
1,3,3-trimethylspiro[2H-indole-2,3'-[3H]pyrido[4,3-f][1,4]benzoxazine], 4-fluoro-1,3,3-trimethylspiro[2H-indole-2,3'-[3H]pyrido[4,3-f][1,4]benzoxazin e],
5-fluoro-1,3,3-trimethylspiro[2H-indole-2,3'-[3H]pyrido[4,3-f][1,4]benzoxazin e],
6-fluoro-1,3,3-trimethylspiro[2H-indole-2,3'-[3H]pyrido[4,3-f][1,4]benzoxazin e],
5-chloro-1,3,3-trimethylspiro[2H-indole-2,3'-[3H]pyrido[4,3-f][1,4]benzoxazin e],
5-bromo-1,3,3-trimethylspiro[2H-indole-2,3'-[3H]pyrido[4,3-f][1,4]benzoxazin e],
1'-methyldispiro[cyc1ohexane-1,3'-[3H]indole-2'(1'H),3"-[3H]pyrido[4,3-f][1, 4]benzoxazine],
4-fluoro-1'-methyldispiro[cyclohexane-1,3'-[3H]indole-2'(1'H),3"-[3H]pyrido[4,3-f][1,4]benzoxazine],
5-fluoro-1'-methyldispiro[cyclohexane-1,3'-[3H]indole-2'(1'H),3"-[3H]pyrido[ 4,3-f][1,4]benzoxazine],
6-fluoro-1'-methyldispiro[cyclohexane-1,3'-[3H]indole-2'(1'H),3"-[3H]pyrido[ 4,3-f][1,4]benzoxazine],
5-chloro-1'-methyldispiro[cyclohexane-1,3'-[3H]indole-2'(1'H),3"-[3H]pyrido[ 4,3-f]-[1,4]benzoxazine] and
5-bromo-1'-methyldispiro[cyclohexane-1,3'-[3H]indole-2'(1'H),3"-[3H]pyrido[4,3-f][1,4]benzoxazine].

Specific examples of the heat-color changing compound are set forth below, but the invention should not be construed as being limited thereto.

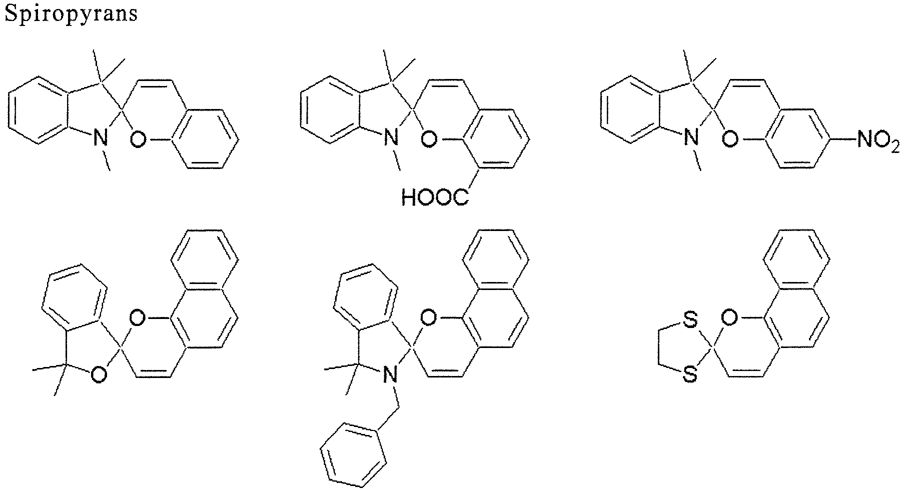

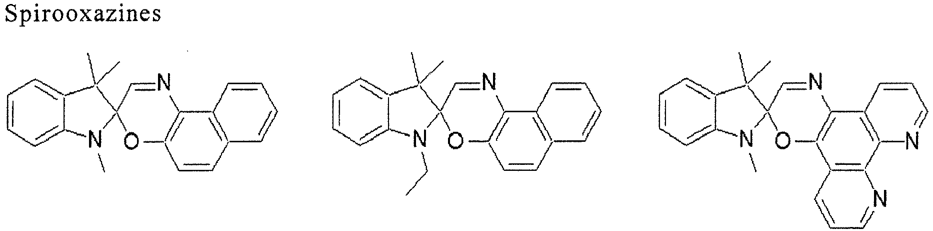

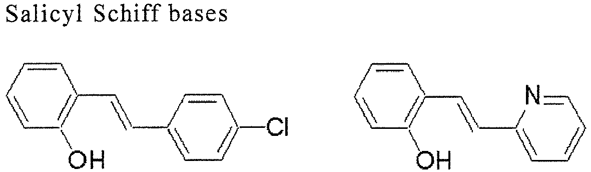

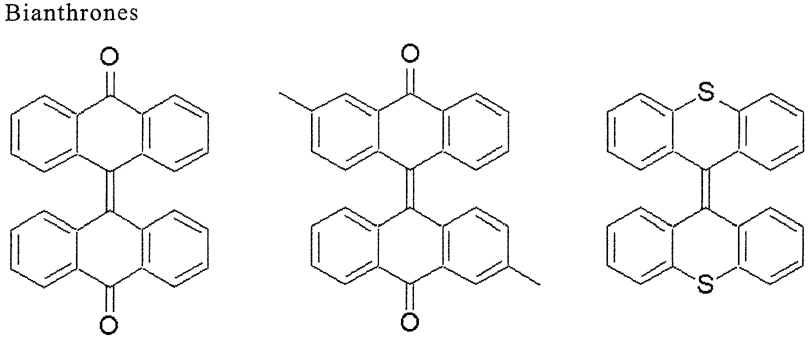

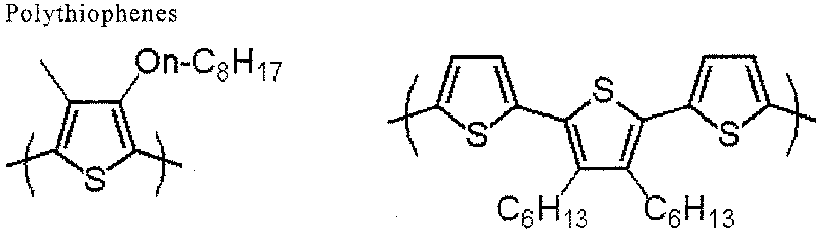

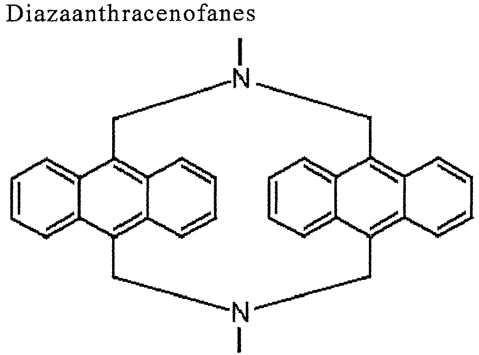

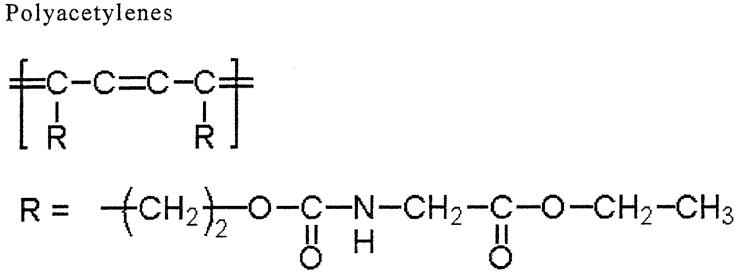

### <Preparation of mesoporous silica having color changing compound incorporated therein>

Preparation of the mesoporous silica having a color changing compound incorporated therein can be performed by dissolving the color changing compound in an appropriate solvent, if desired, together with other component, for example, a color changing aid to prepare a solution of the color changing compound and immersing mesoporous silica in the solution. At the time of immersion of mesoporous silica in the solution it is preferred to stir the solution from the standpoint of accelerating the incorporation of color changing compound into pores of mesoporous silica. The solvent for the preparation of solution of the color changing compound is not particularly restricted as long as it can dissolve the color changing compound and is preferably a highly polar solvent from the standpoint of solubility of the color changing compound or the like. The solvents may be used individually or in combination of two or more thereof. Specifically, the solvent, is preferably at least one kind of solvent selected from a nitrile, a halogenated solvent, an ether, an amide, a sulfoxide, a ketone, an alcohol and water. The nitrile includes, for example, acetonitrile, benzonitrile and butyronitrile. The halogenated solvent includes, for example, chloroform and dichloromethane. The ether includes, for example, THF (tetrahydrofuran). The amide includes, for example, DMF (dimethylformamide). The sulfoxide includes, for example, DMSO (dimethylsulfoxide). The ketone includes, for example, acetone. The alcohol includes, for example, methanol. Of the solvents, acetonitrile is particularly preferred.

The concentration of the color changing compound in the solution of color changing compound is ordinarily from 1.25 × 10⁻⁵ to 1.50 × 10⁻⁴ mol/l, preferably from 5.0 × 20⁻⁵ to 1.50 × 10⁻⁴ mol/l, and particularly preferably from 1.0 × 10⁻⁴ to 1.25 × 10⁻⁴ mol/1. As to the ratio of the color changing compound and the mesoporous silica, the color changing compound is ordinarily from 2.5 × 10⁻⁵ to 3.0 × 10⁻⁴ mol, preferably from 1.0 × 10⁻⁴ to 2.9 × 10⁻⁴ mol, more preferably 2.0 × 10⁻⁴ to 2.5 × 10⁻⁴ mol, per g of the mesoporous silica.

The conditions, for example, temperature or time at the time of immersion of mesoporous silica in the solution of color changing compound are not particularly restricted. The temperature is preferably from 10 to 82°C, and more preferably from 50 to 75°C. The time is preferably from 0.5 to 24 hours, and more preferably from 1 to 6 hours.

The mesoporous silica having a color changing compound incorporated therein obtained as described above may be used as it is as the dispersion or may be used after conducting isolation from the dispersion. In order to remove the excess solvent, it is preferred to use after conducting the isolation. For the purpose of isolating the mesoporous silica having a color changing compound incorporated therein from the dispersion, a conventional method can be used. For instance, it can be performed by collecting the mesoporous silica having a color changing compound incorporated therein by filtration of the dispersion, followed by washing and drying. A solvent used for the washing is not particularly restricted. For example, the solvent which can be used for the immersion described above can be employed. The temperature for drying is also not particularly restricted. It is ordinarily from 15 to 60°C, preferably from 20 to 50°C, and more preferably from 25 to 40°C. The atmosphere at the time of drying is also not particularly restricted. For example, the drying can be conducted in the air or in an inert gas atmosphere. The drying may be conducted at a normal pressure but is preferably conducted under a reduced pressure from the standpoint of drying speed.

The content of the mesoporous silica having a color changing compound incorporated therein in the image-recording layer is preferably from 10 to 50% by weight, more preferably from 20 to 40% by weight, based on the total solid content of the image-recording layer. When the content is too small, the effect of improving the visibility of the visible image is not recognized, whereas when the content is too large, due to the degradation of image strength the printing durability may cause to be decreased.

### (E) Binder polymer

In the image-recording layer according to the invention, a binder polymer can be used for the purpose of improving film strength of the image-recording layer. The binder polymer which can be used in the invention can be selected from those heretofore known without restriction, and a polymer having a film-forming property is preferred. Among them, an acrylic resin, a polyvinyl acetal resin or a polyurethane resin is preferred.

As the binder polymer preferred for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth)acryl group, a vinyl group or an allyl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the on-press development property to the image-recording layer. In particular, coexistence of the crosslinkable group and the hydrophilic group makes it possible to maintain compatibility between the printing durability and on-press development property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units having 2 or 3 carbon atoms is preferred. In particular, a polyethylene oxide structure containing from 2 to 8 ethylene oxide units is preferred. In order to introduce a hydrophilic group into the binder polymer, a monomer having the hydrophilic group may be copolymerized.

In order to control the ink receptivity, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate may be copolymerized.

Specific examples (1) to (11) of the binder polymer for use in the invention are set forth below, but the invention should not be construed as being limited thereto. The ratio of the repeating units is indicated as a molar ratio.

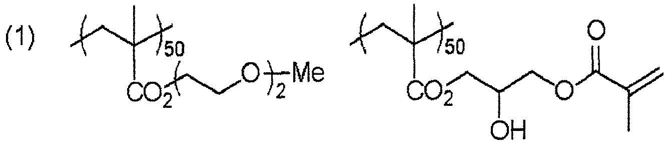

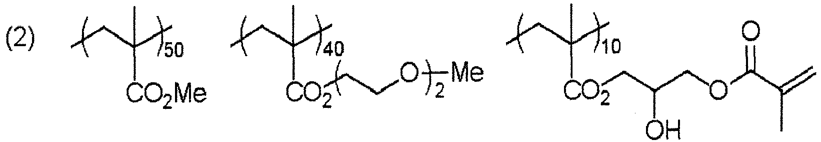

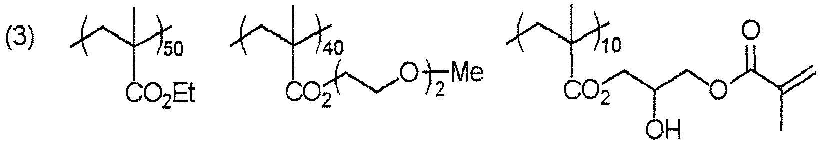

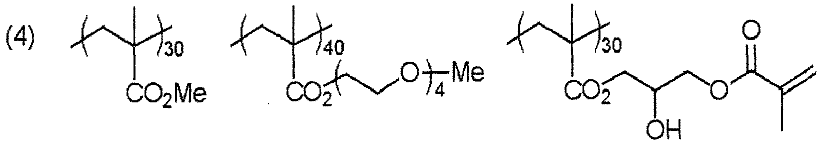

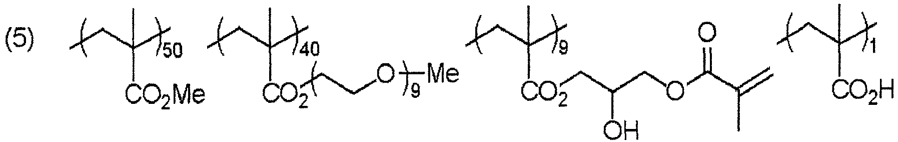

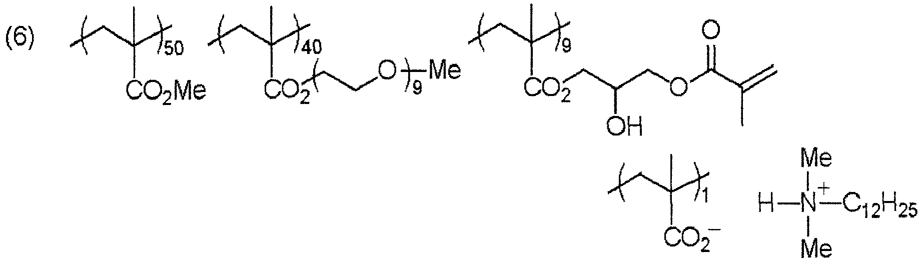

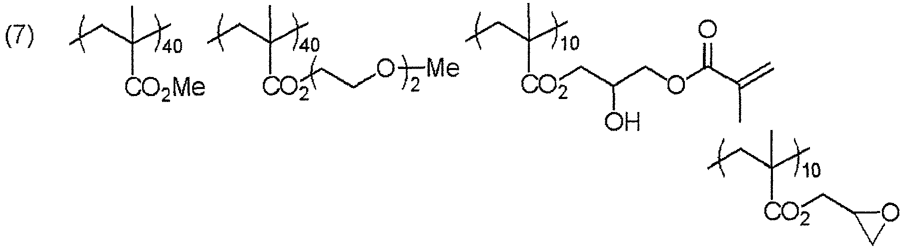

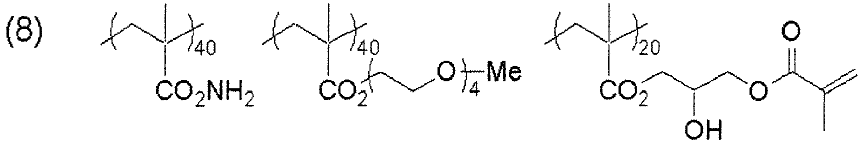

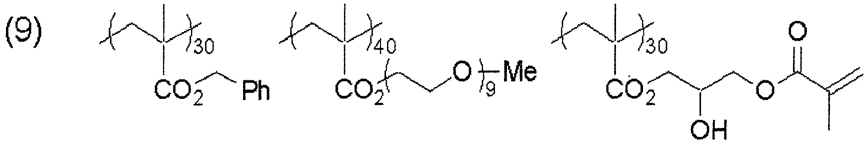

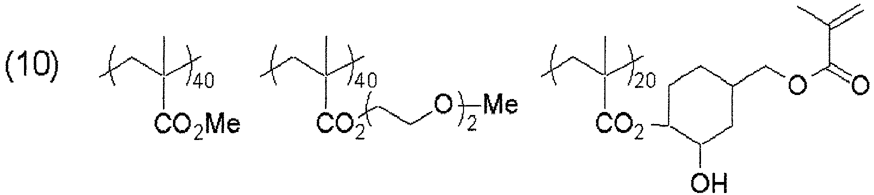

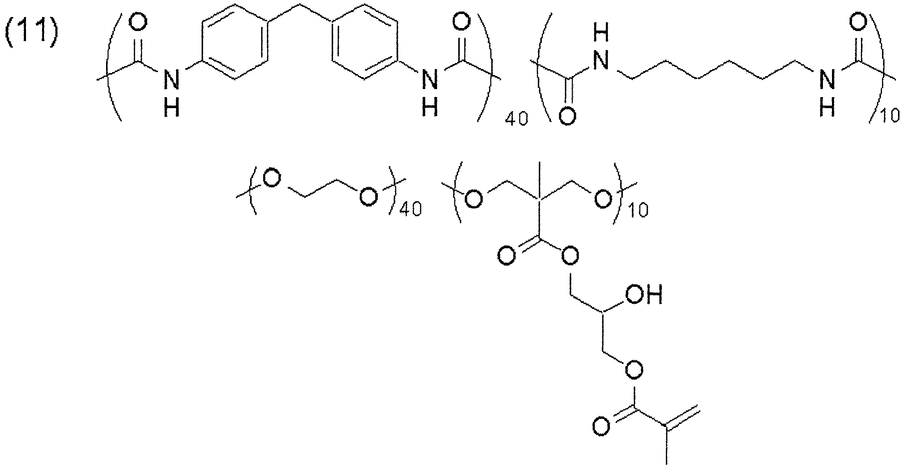

The weight average molecular weight (Mw) of the binder polymer according to the invention is preferably 2,000 or more, more preferably 5,000 or more, and still more preferably from 10,000 to 300,000.

According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.

The content of the binder polymer is ordinarily from 5 to 90% by weight, preferably from 5 to 80% by weight, more preferably from 10 to 70% by weight, based on the total solid content of the image-recording layer.

### (F) Borate compound

The image-recording layer according to the invention preferably contains a borate compound. By incorporating the borate compound into the image-recording layer, strength of the image-recording layer can be increased. Also, in case of using the heat-color changing compound or acid-color changing compound as the color changing compound, the borate compound has also an effect of increasing the color changing property thereof. The borate compound which can be used in the invention is not particularly restricted as long as it has a boron anion structure and is preferably a borate compound having a structure represented by formula (c) shown below.

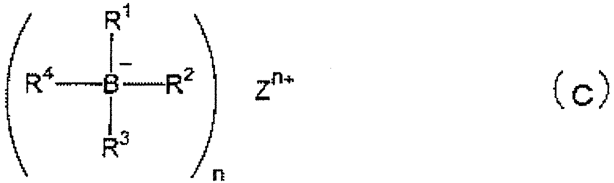

In formula (c), R¹ to R⁴ each independently represents a monovalent organic group, Zⁿ⁺ represents an n-valent cation, and n represents an integer from 1 to 6.

The monovalent organic group represented by any of R¹ to R⁴ includes, for example, an alkyl group, an alkenyl group, an aryl group, an alkynyl group and a cycloalkyl group, and is preferably an aryl group. The monovalent organic group may have a substituent and examples of the substituent capable of being introduced include an alkyl group, a halogenated alkyl group, an alkenyl group, an alkynyl group, an aryl group, a halogen atom, an alkoxy group, an alkoxycarbonyl group, an amino group, a cyano group, an amido group, a urethane group, a sulfo group, a thioalkoxy group and a carboxyl group.

Of the compounds, compounds wherein R¹ to R⁴ each represents an aryl group are preferred, and the aryl group is more preferably an aryl group having an electron withdrawing group as the substituent. R¹ to R⁴ may be the same or different from each other.

The electron withdrawing group introduced into the aryl group is preferably a halogen atom or a fluoroalkyl group, and particularly preferably a fluorine atom or a trifluoromethyl group.

Zⁿ⁺ may be used without restriction as long as it is a cation capable of neutralizing the borate anion. Examples of the cation preferably used include an alkali metal ion, an alkaline earth metal ion and an onium salt, for example, a sulfonium salt, an iodonium salt, an azinium salt, an ammonium salt, a phosphonium salt or a diazonium salt. From the standpoint of development property, an alkali metal ion, for example, Li, Na or K is preferred.

Specific examples of the borate compound preferably used in the invention are set forth below, but the invention should not be construed as being limited thereto.

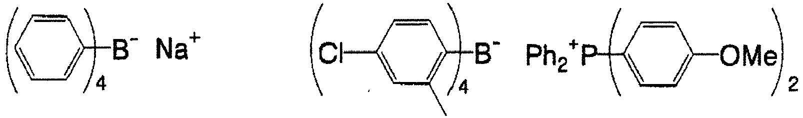

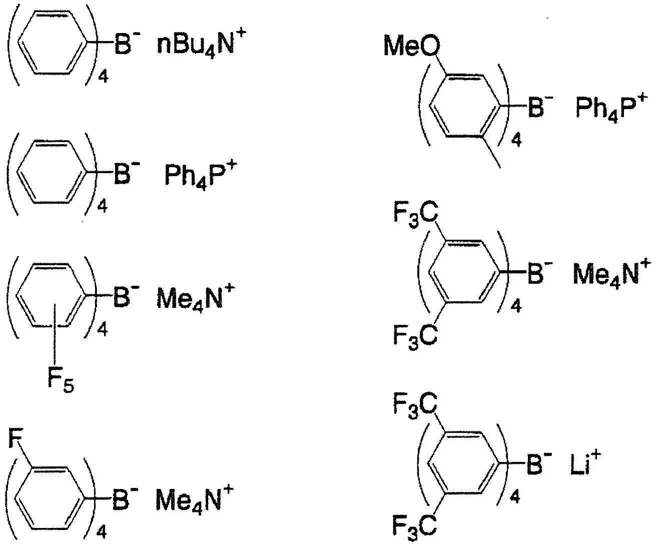

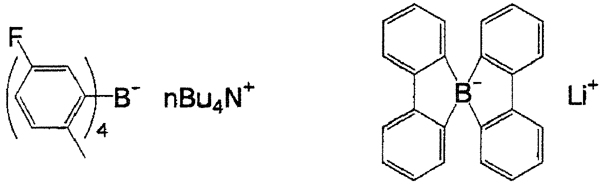

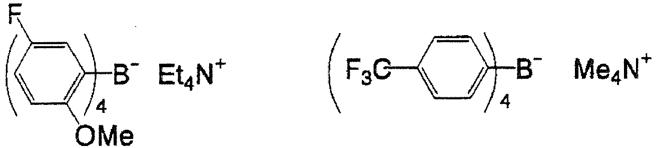

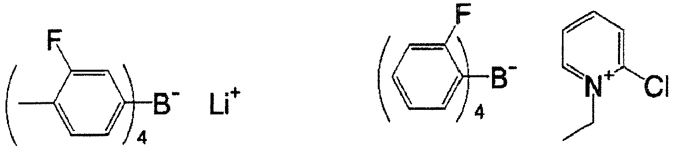

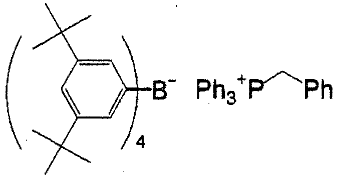

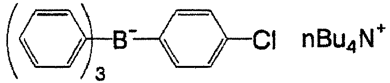

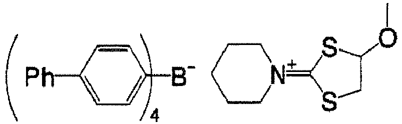

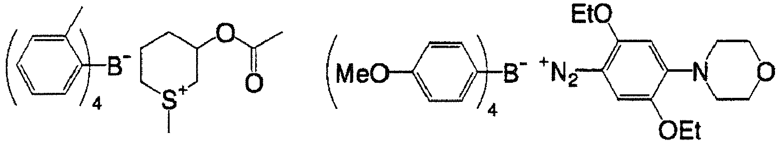

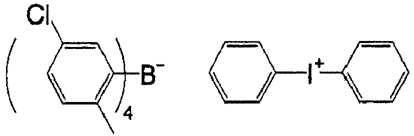

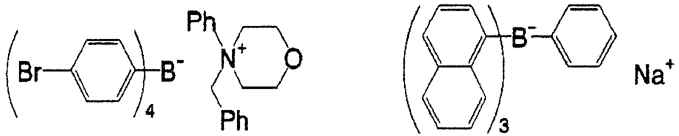

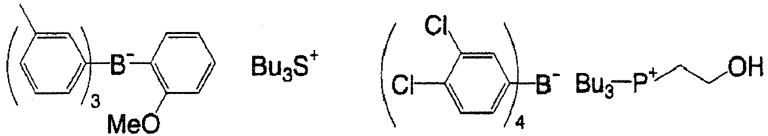

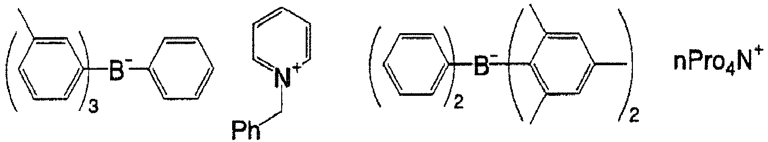

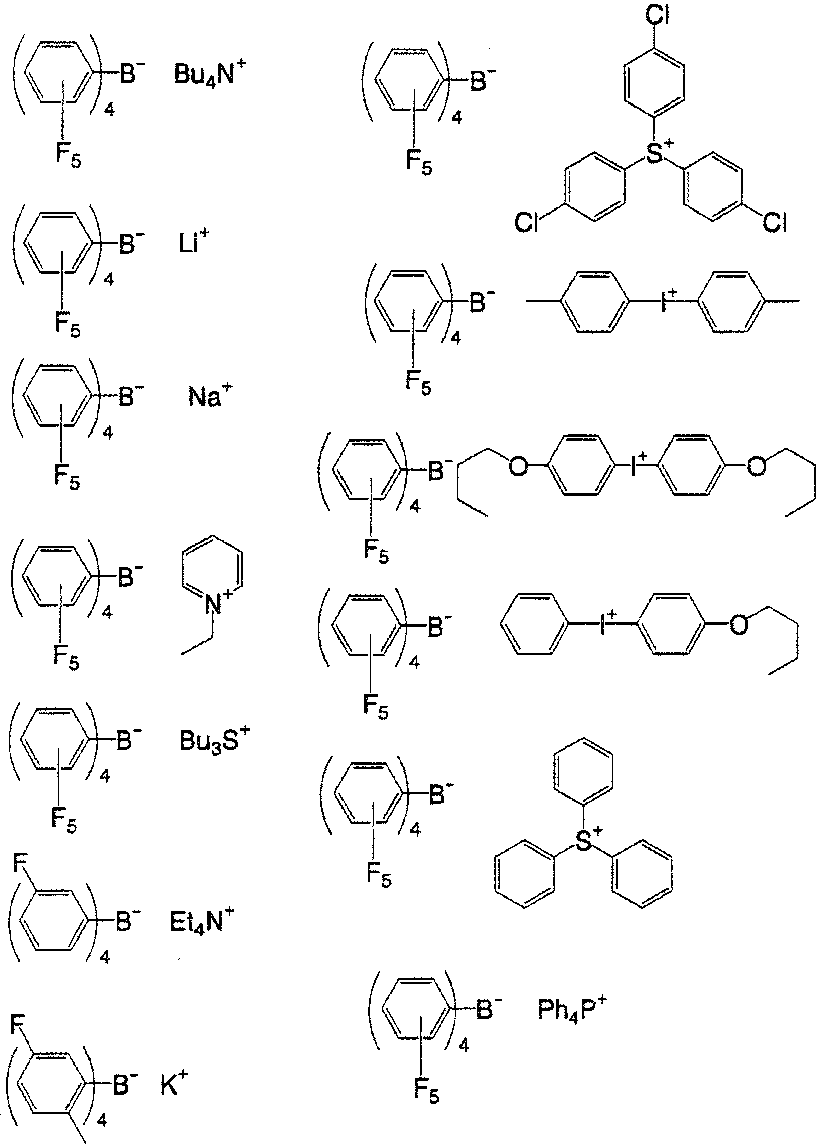

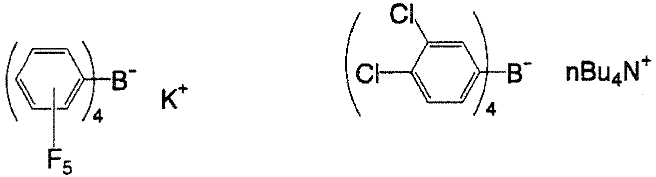

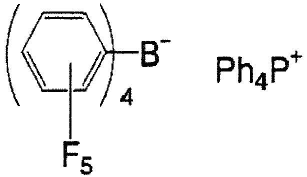

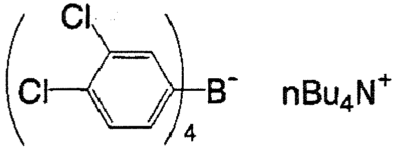

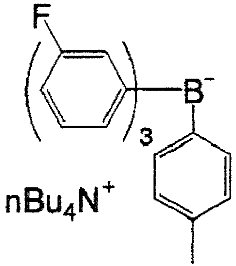

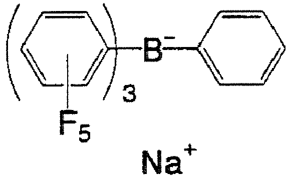

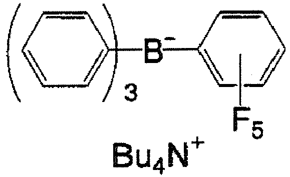

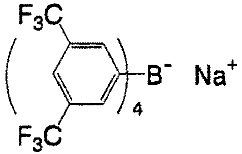

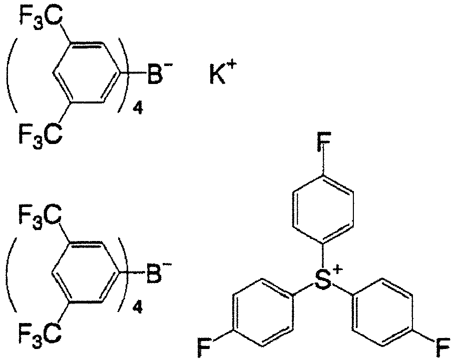

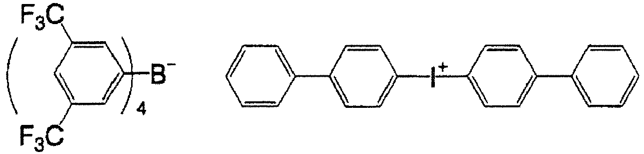

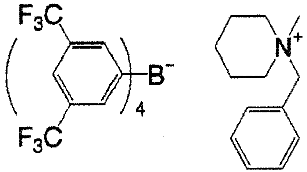

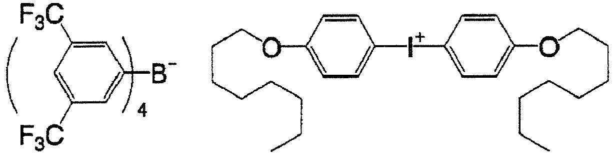

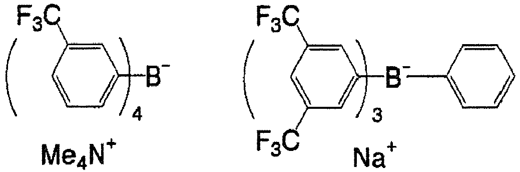

Of the borate compounds, tetraphenyl borate is particularly preferred.

The content of the borate compound in the image-recording layer according to the invention is preferably from 0.1 to 20% by weight, more preferably from 1 to 10% by weight, calculated in terms of solid content, from the standpoint of visibility.

### (G) Polymer fine particle

According to the invention, a polymer fine particle can be used in the image-recording layer in order to improve the on-press development property. A polymer fine particle having a polyalkylene oxide structure is preferred. In particular, a polymer fine particle having a polyalkylene oxide group in its side chain is preferred. By using the polymer fine particle, permeability of dampening water increases, thereby improving the on-press development property.

The polymer fine particle according to the invention is preferably a hydrophobizing precursor capable of converting the image-recording layer to be hydrophobic when heat is applied. The hydrophobizing precursor polymer fine particle is preferably at least one fine particle selected from a hydrophobic thermoplastic polymer fine particle, a thermo-reactive polymer fine particle, a microcapsule having a hydrophobic compound encapsulated and a microgel (crosslinked polymer fine particle). Among them, a polymer fine particle having a polymerizable group and a microgel are preferred. In order to improve the on-press development property, the polymer fine particle preferably contains a polyalkylene oxide structure as described above.

As the hydrophobic thermoplastic polymer fine particle, hydrophobic thermoplastic polymer fine particles described, for example, in Research Disclosure, No. 33303, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is preferred.

The average particle size of the hydrophobic thermoplastic polymer fine particle which can be used in the invention is preferably from 0.01 to 2.0 µm.

The thermo-reactive polymer fine particle which can be used in the invention includes a polymer fine particle having a thermo-reactive group and forms a hydrophobized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxy group or an amino group as the reaction partner thereof, and an acid anhydride performing a ring opening addition reaction and an amino group or a hydroxy group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel can contain a part of the constituting components of the image-recording layer at least in the inside and on the surface thereof. Particularly, an embodiment of a reactive microgel containing the polymerizable compound on the surface thereof is preferred from the standpoint of the image-forming sensitivity and printing durability.

As a method of microencapsulation or microgelation of the constituting components of the image-recording layer, known methods can be used.

The average particle size of the microcapsule or microgel is preferably from 0.01 to 3.0 µm, more preferably from 0.05 to 2.0 µm, and particularly preferably from 0.10 to 1.0 µm. In the range described above, good resolution and good time-lapse stability can be achieved.

The content of the polymer fine particle is preferably from 5 to 90% by weight based on the total solid content of the image-recording layer.

### (H) Other components

### (1) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyhydroxy compound, e.g., glycerol, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-triaxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; and an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphthalenedisulfonate or trisodium 1,3,6-naphthalenetrisulfonate; compounds described in Paragraph Nos. [0026] to [0031] of JP-A-2007-276454 and Paragraph Nos. [0020] to [0047] of JP-A-2009-154525. The salt may also be a potassium salt or a lithium salt.

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt. Specific examples of the organic sulfate include compounds described in Paragraph Nos. [0034] to [0038] of JP-A-2007-276454.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added is preferably from 0.5 to 20% by weight, more preferably from 1 to 15% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

### (2) Oil-sensitizing agent

In order to improve the ink receptivity, an oil-sensitizing agent (so-called "sensitizing agent"), for example, a phosphonium compound, a nitrogen-containing low molecular weight compound or an ammonium group-containing polymer may be incorporated into the image-recording layer according to the invention. In particular, in the case where an inorganic stratiform compound is incorporated into a protective layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples of the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples of the ammonium group-containing polymer include polymers described in Paragraph Nos. [0089] to [0105] of JP-A-2009-208458.

Specific examples of the ammonium group-containing polymer are set forth below.
(1) 2-(Trimethylammonio)ethyl methacrylate p-toluenesulfonate/3,6-dioxaheptyl methacrylate copolymer (molar ratio: 10/90, Mw: 45,000)
(2) 2-(Trimethylammonio)ethyl methacrylate hexafluorophosphate /3,6-dioxaheptyl methacrylate copolymer (molar ratio: 20/80, Mw: 60,000)
(3) 2-(Ethyldimethylammonio)ethyl methacrylate p-toluenesulfonate/hexyl methacrylate copolymer (molar ratio: 30/70, Mw: 45,000)
(4) 2-(Trimethylammonio)ethyl methacrylate hexafluorophosphate /2-ethylhexyl methacrylate copolymer (molar ratio: 20/80, Mw: 60,000)
(5) 2-(Trimethylammonio)ethyl methacrylate methylsulfate/hexyl methacrylate copolymer (molar ratio: 40/60, Mw: 70,000)
(6) 2-(Butyldimethylammonio)ethyl methacrylate
   hexafluorophosphate/3,6-dioxaheptyl methacrylate copolymer (molar ratio: 25/75, Mw: 65,000)
(7) 2-(Butyldimethylammonio)ethyl acrylate
   hexafluorophosphate/3,6-dioxaheptyl methacrylate copolymer (molar ratio: 20/80, Mw: 65,000)
(8) 2-(Butyldimethylammonio)ethyl methacrylate
   13-methyl-5,8,11-trioxa-1-heptadecanesulfonate/3,6-dioxaheptyl methacrylate copolymer (molar ratio: 20/80, Mw: 75,000)
(9) 2-(Butyldimethylammonio)ethyl methacrylate hexafluorophosphate/3,6-dioxaheptyl
   methacrylate/2-hydroxy-3-methacryloyloxypropyl methacrylate copolymer (molar ratio: 15/80/5, Mw: 65,000)

As to the ammonium group-containing polymer, its reduced specific viscosity value (unit: ml/g) determined according to the measuring method described in JP-2009-208458 is preferably from 5 to 120, more preferably from 10 to 110, particularly preferably from 15 to 100. When the reduced specific viscosity value described above is calculated in terms of weight average molecular weight (Mw), from 10,000 to 150,000 is preferred, from 17,000 to 140,000 is more preferred, and 20,000 to 130,000 is particularly preferred.

The content of the oil-sensitizing agent is preferably from 0.01 to 30.0% by weight, more preferably from 0.1 to 15.0% by weight, still more preferably from 1 to 10% by weight, based on the total solid content of the image-recording layer.

### (3) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

### [Formation of image-recording layer]

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 g/m², more preferably from 0.5 to 2.0 g/m² and particularly preferably from 0.8 to 1.5 g/m².

### [Support]

As the support which can be used in the lithographic printing plate precursor according to the invention, a known support is employed. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 µm.

### [Undercoat layer]

In the lithographic printing plate precursor according to the invention, an undercoat layer may be provided between the support and image-recording layer. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

The compound for use in the undercoat layer preferably includes a compound having a functional group capable of interacting with the surface of aluminum support and, in order to increase an adhesion property to the image-recording layer, a crosslinkable group, particularly a group having an ethylenically unsaturated bond. Further, a compound having a hydrophilicity-imparting group, for example, a sulfo group is also preferably exemplified. Such a compound may be a low molecular weight compound or a polymer compound. Also, such compounds may be used as a mixture of two or more thereof.

In case of using the polymer, a copolymer of a monomer having a functional group capable of interacting with the surface of aluminum support, a monomer having an ethylenically unsaturated bond in its side chain and a monomer having a hydrophilic group is preferred.

The undercoat layer according to the invention may contain a chelating agent, a secondary or tertiary amine, a polymerization inhibitor or a compound containing an amino group or a functional group having polymerization inhibition ability and a group capable of interacting with the surface of aluminum support (for example, 1,4-diazobicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid).

The undercoat layer is coated according to a known method. The coating amount (solid content) of the undercoat layer is preferably from 0.1 to 100 mg/m², and more preferably from 1 to 30 mg/m².

### [Protective layer]

In the lithographic printing plate precursor according to the invention, a protective layer may be preferably provided on the image-recording layer, in order to prevent diffusion and penetration of oxygen which inhibits the polymerization reaction at the time of exposure. As a material which can be used in the protective layer, any water-soluble polymer and water-insoluble polymer may be appropriately selected to use. The polymers may be used as a mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Of the polymers, a water-soluble polymer relatively excellent in crystallizability is preferably used. Specifically, when polyvinyl alcohol is used as the main component, particularly preferred results are obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree in a range from 69.0 to 100% by mole and a polymerization repeating unit number in a range from 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). Polyvinyl alcohols can be used individually or as a mixture. The content of polyvinyl alcohol in the protective layer is preferably from 20 to 95% by weight, and more preferably from 30 to 90% by weight.

Also, a modified polyvinyl alcohol can be preferably used. Particularly, an acid-modified polyvinyl alcohol having a carboxylic acid group or a sulfonic acid group is preferably used. Specifically, polyvinyl alcohols described in JP-A-2005-250216 and JP-A-2006-259137 are exemplified.

In the case of using other material as a mixture with polyvinyl alcohol, the material mixed with polyvinyl alcohol is preferably a modified polyvinyl alcohol, polyvinyl pyrrolidone or a modified product thereof from the standpoint of the oxygen-blocking property and removability by development. The content thereof is preferably from 3.5 to 80% by weight, more preferably from 10 to 60% by weight, still more preferably from 15 to 30% by weight, in the protective layer.

As other component of the protective layer, glycerin, dipropylene glycol or the like can be added in an amount of several % by weight of the polymer material to provide flexibility. Further, an anionic surfactant, for example, sodium alkylsulfate or sodium alkylsulfonate, an amphoteric surfactant, for example, alkylaminocarboxylate or alkylaminodicarboxylate, or a nonionic surfactant, for example, polyoxyethylene alkyl phenyl ether can be added in an amount of several % by weight of the polymer material.

Further, it is also preferred to incorporate an inorganic stratiform compound into the protective layer of the lithographic printing plate precursor according to the invention for the purpose of increasing the oxygen-blocking property and property for protecting the surface of image-recording layer. Of the inorganic stratiform compounds, fluorine-based swellable synthetic mica, which is a synthetic inorganic stratiform compound, is particularly preferred. Specifically, inorganic stratiform compounds described in JP-A-2005-119273 are exemplified.

Moreover, protective layers described in U.S. Patent 3,458,311, JP-B-55-49729, JP-A-2008-15503, JP-A-2008-89916 and Paragraph Nos. [0211] to [0261] of JP-A-2008-139813 are also preferably used.

The coating amount of the protective layer is preferably from 0.05 to 10 g/m² in terms of the coating amount after drying. The coating amount is more preferably from 0.1 to 5 g/m² in the case where the protective layer contains the inorganic stratiform compound, and it is more preferably from 0.5 to 5 g/m² in the case where the protective layer does not contain the inorganic stratiform compound.

### [Plate making method]

Plate making of the lithographic printing plate precursor according to the invention is preferably performed by an on-press development method. The plate making according to the on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the image-recording layer of the lithographic printing plate precursor is removed in the course of the printing step.

As the light source used for the image exposure a laser is preferred. The laser for use in the invention is not particularly restricted and preferably includes, for example, a solid laser or semiconductor laser emitting an infrared ray having a wavelength of 760 to 1,200 nm.

With respect to the infrared ray laser, the output is preferably 100 mW or more, the exposure time per pixel is preferably within 20 microseconds, and the irradiation energy amount is preferably from 10 to 300 mJ/cm². With respect to the laser exposure, in order to shorten the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the image exposure.

When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres on the revealed hydrophilic surface and the printing ink adheres to the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

### EXAMPLES

The present invention will be described in detail with reference to the following examples, but the invention should not be construed as being limited thereto. With respect to a polymer compound, unless otherwise specified, a molecular weight of the polymer compound means a weight average molecular weight (Mw) and a ratio of repeating units is indicated as a mole percent.

### Examples 1 to 14 and Comparative Examples 1 to 3

### [1] Preparation of Lithographic printing plate precursors (1) to (14)

### (1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in a 25% by weight aqueous sodium hydroxide solution of 45°C for 9 seconds, washed with water, then immersed in a 20% by weight nitric acid solution at 60°C for 20 seconds, and washed with water. The etching amount of the grained surface was about 3 g/m².

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolytic solution above using as an electrolytic solution, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying.

The plate was then subjected to an anodizing treatment using as an electrolytic solution, a 15% by weight aqueous sulfuric acid solution (containing 0.5% by weight of aluminum ion) at a current density of 15 A/dm² to form a direct current anodized film of 2.5 g/m², washed with water and dried to prepare Support (1).

Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/m². The center line average roughness (Ra) of the support was measured using a stylus having a diameter of 2 µm and found to be 0.51 µm.

### (2) Formation of Undercoat layer

Coating solution (1) for undercoat layer shown below was coated on Support (2) described above so as to have a dry coating amount of 20 mg/m² to prepare a support having an undercoat layer.

### <Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

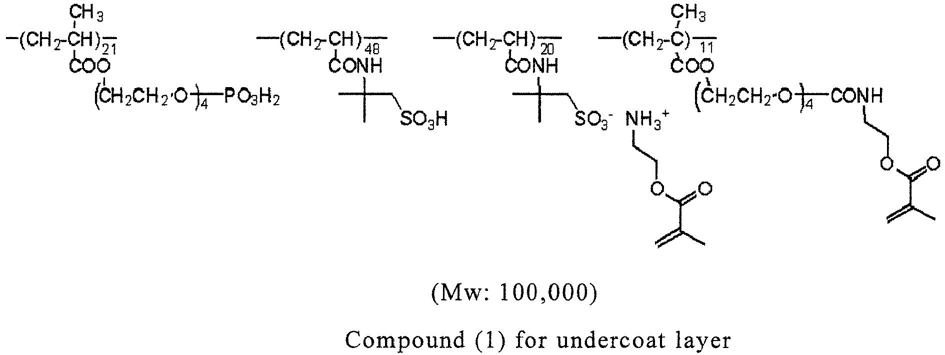

### (3) Formation of Image-recording layer

Coating solution (A) for image-recording layer having the composition shown below was coated on the undercoat layer formed as described above by a bar and dried in an oven at 100°C for 60 seconds to form an image-recording layer having a dry coating amount of 1.0 g/m².

Coating solution (A) for image-recording layer was prepared by mixing Photosensitive liquid (1) shown below, Microgel liquid (1) shown below and the mesoporous silica having a color changing compound incorporated therein just before the coating, followed by stirring.

### <Photosensitive liquid (1)>

| | |
|---|---|
| Binder polymer (1) having structure shown below | 0.240 g |
| Infrared absorbing agent (1) having structure shown below | 0.030 g |
| Radical generator (1) having structure shown below | 0.162 g |
| Polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (1) (Tris(2-hydroxyethyl) isocyanurate) | 0.062 g |
| Hydrophilic low molecular weight compound (2) having structure shown below | 0.050 g |
| Oil-sensitizing agent (1) (Phosphonium compound (1) having structure shown below) | 0.055 g |
| Oil-sensitizing agent (2) (Benzyl dimethyl octyl ammonium PF₆ salt) | 0.018 g |
| Oil-sensitizing agent (3) (Ammonium group-containing polymer having structure shown below (reduced specific viscosity: 44 cSt/g/ml) | 0.035 g |
| Fluorine-based surfactant (1) having structure shown below | 0.008 g |
| 2-Butanone | 1.091 g |
| 1-Methoxy-2-propanol | 8.609 g |

### <Microgel liquid (1)>

| | |
|---|---|
| Microgel (1) shown below | 2.640 g |
| Distilled water | 2.425 g |

### <Mesoporous silica having color changing compound incorporated therein>

| | |
|---|---|
| Mesoporous silica having color changing compound incorporated therein shown in Table 1 below | Amount shown in Table 1 below |

The structures of Binder polymer (1), Infrared absorbing agent (1), Radical generator (1), Hydrophilic low molecular weight compound (2), Oil-sensitizing agent (1), Oil-sensitizing agent (3) and Fluorine-based surfactant (1) are shown below. 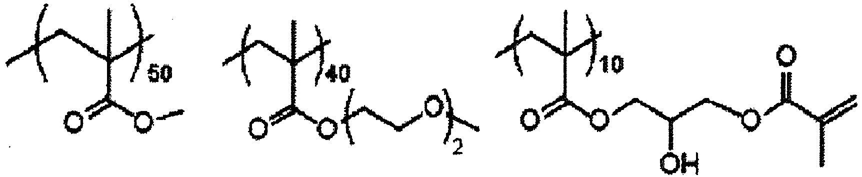 (Mw: 70,000)

Binder polymer (1)

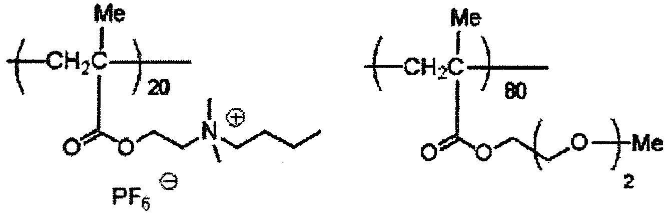

Oil-sensitizing agent (3)

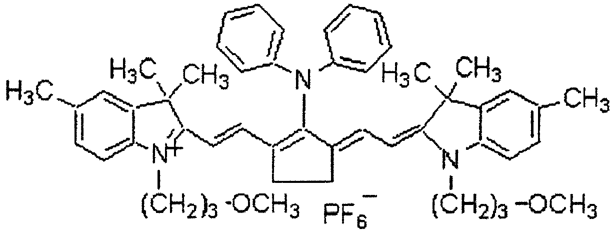

Infrared absorbing agent (1)

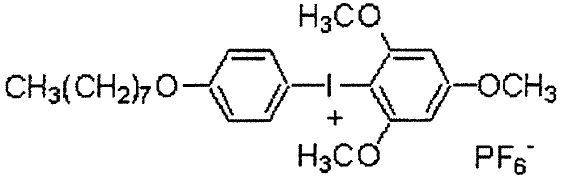

Radical generator (1)

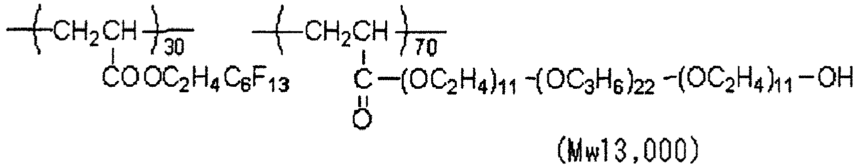

Fluorine-based surfactant (1)

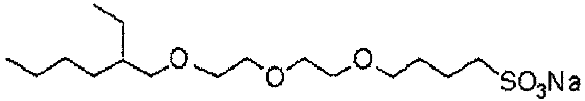

Hydrophilic low molecular weight compound (2)

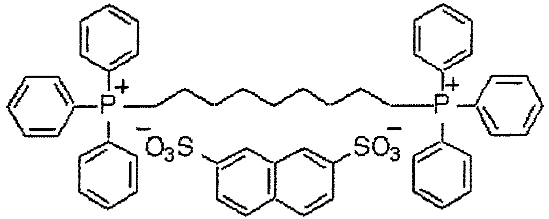

### Oil-sensitizing agent (1)

### <Preparation of Microgel (1)>

An oil phase component was prepared by dissolving 4.46 g of polyfunctional isocyanate having the structure shown below (produced by Mitsui Chemicals Polyurethane, Inc., 75% by weight ethyl acetate solution), 0.86 g of adduct obtained by addition of trimethylolpropane (6 mol) and xylene diisocyanate (18 mol) and further addition of methyl-terminated polyoxyethylene (1 mol) (number of oxyethylene repeating unit: 90) (produced by Mitsui Chemicals Polyurethane, Inc., 50% by weight ethyl acetate solution), 1.72 g of pentaerythritol tetraacrylate (SR399E, produced by Sartomer Co.) and 0.05 g of PIONIN A-41C (produced by Takemoto Oil & Fat Co., Ltd., 70% by weight methanol solution) in 4.46 g of ethyl acetate. The oil phase component and 17.30 g of water as an aqueous phase component were mixed and emulsified using a homogenizer at 10,000 rpm for 15 minutes. The resulting emulsion was stirred at 40°C for 4 hours. The microgel liquid thus-obtained was diluted using water so as to have the solid content concentration of 21.8% by weight, thereby preparing Microgel (1). The average particle size of the microgel was 0.25 µm.

Polyfunctional isocyanate

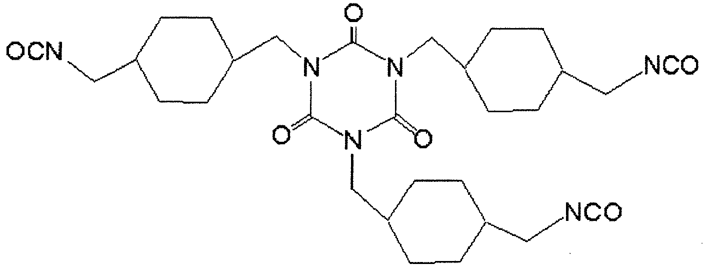

### <Preparation of Mesoporous silica having color changing compound incorporated therein>

### 1) Preparation of Mesoporous silica 2 having color changing compound incorporated therein

To 100 ml of acetonitrile was dispersed 1.0 g of mesoporous silica particle (particle size: 200 nm, pore size: 4 nm, produced by Sigma-Aldrich Co.) and the mixture was stirred at room temperature for 3 hours. To the mixture was added 0.1 g of 3-aminopropyltrimethoxysilane (produced by Shin-Etsu Silicone Co., Ltd.) followed by stirring at room temperature for 24 hours, thereby conducting a hydrophilizing treatment of the surface of mesoporous silica particle. The resulting suspension was filtered to separate a solid and the solid was dried at 25°C for 6 hours using a vacuum line to obtain hydrophilizing surface-modified mesoporous silica particle.

To 25 ml of an acetonitrile solution containing 4 × 10⁻³ mol/l of Photo-color changing compound A (Infrared absorbing agent (1) shown above) and 4 × 10⁻³ mol/l of Iodonium salt A (Radical generator (1) shown above) was added 0.25 g of the hydrophilizing surface-modified mesoporous silica particle followed by stirring at room temperature for 12 hours to obtain a blue colored suspension. The mesoporous silica particle was separated by filtration and dried at 25°C for 6 hours using a vacuum line to obtain Mesoporous silica 2 having color changing compound incorporated therein.

### 2) Preparation of Mesoporous silica 1, 4 to 8 and 10 having color changing compound incorporated therein

### 2-1) Preparation of mesoporous silica particle

Mesoporous silica particles 7, 8 and 10 each having a controlled particle size were prepared according to the description in Chem. Mater., 2002, 14, pp. 4721-4728, "Synthesis of Nanoscale Mesoporous Silica Spheres with Controlled Particle Size".

### <Mesoporous silica particle 7>

To 442 ml of distilled water was added 10.8 g of 29% by weight aqueous ammonia. The solution was heated to 50°C and 0.28 g of CTAB (cetyltrimethylammonium bromide) was added thereto under conditions of vigorous stirring. The solution was turned to room temperature and 1.4 ml of TEOS (tetraethyl orthosilicate) was added thereto under conditions of vigorous stirring. After further stirring for 2 hours, the solid was collected by filtration and calcined at 540°C for 6 hours to obtain Mesoporous silica particle 7.

### <Mesoporous silica particle 8>

To 330 ml of distilled water was added 10.8 g of 29% by weight aqueous ammonia. The solution was heated to 50°C and 0.28 g of CTAB was added thereto under conditions of vigorous stirring. The solution was turned to room temperature and 1.4 ml of TEOS was added thereto under conditions of vigorous stirring. After further stirring for 2 hours, the solid was collected by filtration and calcined at 540°C for 6 hours to obtain Mesoporous silica particle 8.

### <Mesoporous silica particle 10>

To 221 ml of distilled water was added 10.8 g of 29% by weight aqueous ammonia. The solution was heated to 50°C and 0.28 g of CTAB was added thereto under conditions of vigorous stirring. The solution was turned to room temperature and 1.4 ml of TEOS was added thereto under conditions of vigorous stirring. After further stirring for 2 hours, the solid was collected by filtration and calcined at 540°C for 6 hours to obtain Mesoporous silica particle 10.

Mesoporous silica particles 1 and 4 to 6 each having a controlled pore size were prepared according to the description in JP-A-2004-277270 and JP-A-2001-261326.

### <Mesoporous silica particle 1>

To distilled water was dissolved 12.76 g (0.035 mol) of cetyltrimethylammonium bromide (CTAB) at 35°C with stirring. To the aqueous solution was added 167 ml of an aqueous solution containing 22.26 g (0.1 mol) of sodium silicate and the mixed solution was stirred for 20 minutes. The pH of the mixed solution was adjusted to 10 with diluted sulfuric acid (1M). The composition (by mole) of the mixed solution was SiO₂:CTAB:H₂O = 1.00:0.35:100. The mixed solution was further stirred for one hour and transferred to a polypropylene bottle, and the temperature was gradually raised in an oven to be ripened at 120°C. The solid product obtained by filtration was washed with distilled water, dried in the air at room temperature, calcined at 560°C for 6 hours to remove CTAB thereby obtaining 1 g of Mesoporous silica particle 1. The average pore size measured by a nitrogen adsorption BET method was 2 nm.

### <Mesoporous silica particle 4>

Into a one-liter separable flask equipped with a condenser, a stirring motor and a thermometer were charged 25.0 g of a nonionic surfactant (ADEKA PLURONIC P-103, produced by Adeka Corp., hereinafter also abbreviated as P103) as Surfactant (a) and 721 g of purified water and the mixture was stirred at room temperature to be dissolved. Then, 50.0 g of a sodium silicate solution (water glass) No. 3 (produced by Kishida Chemical Co., Ltd.) was added thereto, the temperature was raised to 35°C with stirring, then 135 ml of concentrated hydrochloric acid was added thereto as an acid source, followed by stirring at reaction temperature of 35°C for 4 hours. Thereafter, the stirring was terminated, and the reaction solution was preserved at 95°C for 48 hours and then filtered to separate Silica surfactant composite (b) produced. To the resulting Silica surfactant composite (b) was added 400 ml of ethanol and the mixture was stirred using a stirring motor to remove most of P103 contained in Silica surfactant composite (b) by washing. The resulting silica was further washed purified water until pH of the washing solution reached 5 or more, and 300 to 400 ml of ethanol was added to the silica and stirring and washing were performed 5 times. Thereafter, the silica was dried at 80°C for 24 hours to obtain Mesoporous silica particle 4 as white powder. The average pore size measured by a nitrogen adsorption BET method was 10 nm.

### <Mesoporous silica particle 5>

In the same manner as described above, 25.0 g of the nonionic surfactant (ADEKA PLURONIC P-103) as Surfactant (a) and 654 g of purified water were charged and the mixture was stirred at room temperature to be dissolved. Then, 50.0 g of a sodium silicate solution (water glass) No. 3 (produced by Kishida Chemical Co., Ltd.) and 50.0 g of mesitylene (1,3,5-trimethylbenzene) as Additive (c) were added thereto, the temperature was raised to 35°C with stirring, then 135 ml of concentrated hydrochloric acid was added thereto as an acid source, followed by stirring at reaction temperature of 35°C for 20 hours. Thereafter, the stirring was terminated, and the reaction solution was preserved at 80°C for 48 hours and then filtered to separate Silica surfactant composite (b) produced. To the resulting Silica surfactant composite (b) was added 400 ml of ethanol and the mixture was stirred using a stirring motor to remove most of P103 contained in Silica surfactant composite (b) by washing. The resulting silica was further washed purified water until pH of the washing solution reached 5 or more, and 300 to 400 ml of ethanol was added to the silica and stirring and washing were performed 5 times. Thereafter, the silica is dried at 80°C for 24 hours to obtain Mesoporous silica particle 5 as white powder. The average pore size measured by a nitrogen adsorption BET method was 25 nm.

### <Mesoporous silica particle 6>

In the same manner as described above, 25.0 g of the nonionic surfactant (ADEKA PLURONIC P-103) as Surfactant (a) and 654 g of purified water were charged and the mixture was stirred at room temperature to be dissolved. Then, 50.1 g of a sodium silicate solution (water glass) No. 3 and 50.0 g of mesitylene as Additive (c) were added thereto, the temperature was raised to 35°C with stirring, then 135 ml of concentrated hydrochloric acid was added thereto as an acid source, followed by stirring at reaction temperature of 60°C for 4 hours. Then, the stirring was terminated, and the reaction solution was preserved at 95°C for 48 hours. Thereafter, the reaction solution was subjected to the after-treatment washing in the same manner as described above to obtain Mesoporous silica particle 6. The average pore size measured by a nitrogen adsorption BET method was 50 nm.

Also, the modified mesoporous silica particles described below were employed as the mesoporous silica particle.
Mesoporous silica 2A (propylamine group-modified mesoporous silica, particle size: 200 nm, pore size: 4 nm, produced by Sigma-Aldrich Co.)
Mesoporous silica 2B (propyl carboxylic acid group-modified mesoporous silica, particle size: 200 nm, pore size: 4 nm, produced by Sigma-Aldrich Co.)
Mesoporous silica 2C (propylthiol group-modified mesoporous silica, particle size: 200 nm, pore size: 4 nm, produced by Sigma-Aldrich Co.) 2-2) Preparation of Mesoporous silica 1, 2A to 2C, 4 to 8 and 10 having color changing compound incorporated therein

Mesoporous silica 1, 2A to 2C, 4 to 8 and 10 having color changing compound incorporated therein were prepared in the same manner as in Preparation of Mesoporous silica 2 having color changing compound incorporated therein excepting for using Mesoporous silica particles 1, 2A to 2C, 4 to 8 and 10 in place of the mesoporous silica particle (particle size: 200 nm, pore size: 4 nm, produced by Sigma-Aldrich Co.) used in Preparation of Mesoporous silica 2 having color changing compound incorporated therein, respectively.

### [II] Preparation of Lithographic printing plate precursors (R1) to (R3) for comparison

Lithographic printing plate precursor (R1) for Comparative Example 1 was prepared in the same manner as in Lithographic printing plate precursor (1) excepting for eliminating the mesoporous silica having color changing compound incorporated therein in Coating solution (A) for image-recording layer.

Lithographic printing plate precursor (R2) for Comparative Example 2 was prepared in the same manner as in Lithographic printing plate precursor (1) excepting for eliminating the mesoporous silica having color changing compound incorporated therein in Coating solution (A) for image-recording layer and in place thereof adding 4 × 10⁻³ mol of Photo-color changing compound A and 4 × 10⁻³ mol of Iodonium salt A.

Lithographic printing plate precursor (R3) for Comparative Example 3 was prepared in the same manner as in Lithographic printing plate precursor (1) excepting for eliminating the mesoporous silica having color changing compound incorporated therein in Coating solution (A) for image-recording layer and in place thereof adding 0.25 g of Mesoporous silica particle 2 (particle size: 200 nm, pore size: 4 nm, produced by Sigma-Aldrich Co.), 4 × 10⁻³ mol of Photo-color changing compound A and 4 × 10⁻³ mol of Iodonium salt A.

### [Exposure, Printing and Evaluation of Lithographic printing plate precursor]

Using the lithographic printing plate precursor prepared, the exposure, on-press development and printing were performed and the plate inspection property, on-press development property and printing durability were evaluated in the manner described below. The results obtained are shown in Table 1.

### <Exposure>

The lithographic printing plate precursor was exposed by TRENDSETTER 3244VX (produced by Creo Co.) equipped with a water-cooled 40 W infrared semiconductor laser under the conditions of output of 11.7 W, a rotational number of an external drum of 250 rpm and resolution of 2,400 dpi. The exposed image contained a solid image area and a fine line chart.

### <Evaluation of Plate inspection property (print-out property): Determination of ΔL>

As to ease of plate inspection (plate inspection property) of the exposed lithographic printing plate precursor, using the L value (luminance) of L*a*b* color system, a difference (ΔL) between the L value of the exposed area and the L value of the unexposed area was determined. As the value of ΔL is larger, it is meant that the plate inspection property is more excellent. The measurement was conducted according to SCE (specular competent exclude) system using a spectral colorimeter CM2600d and an operation soft CM-S100W each produced by Konica Minolta Holdings, Inc. According to the SCE system, since the specular light is excluded and only the diffusion light is measured, evaluation of color close to evaluation with visual observation is conducted and the result well correlates with the practical human plate inspection. The determinations of ΔL were conducted just after the exposure (within 30 minutes) and at 6 hour lapse after the exposure.

### <Evaluation of On-press development property>

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and FUSION-G (N) Black Ink (produced by DIC Graphics Corp.), the dampening water and ink were supplied according to the standard automatic printing start method of LITHRONE 26 to conduct printing on 500 sheets of TOKUBISHI ART PAPER (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property. As the number of printing papers is smaller, it is meant that the on-press development property is more excellent.

### <Printing durability>

After performing the evaluation for the on-press development property described above, the printing was continued. As the increase in a number of printing papers, the image-recording layer was gradually abraded to cause decrease in the ink density on the printing paper. A number of the printing papers wherein a value obtained by measuring a halftone dot area rate of the 50% halftone dot of AM screen on the printing paper using a Gretag densitometer decreased by 5% from the value measured on the 100th paper of the printing was determined to evaluate the printing durability.

From the results shown in Table 1, it can be seen that the lithographic printing plate precursor containing the mesoporous silica having a color changing compound incorporated therein in the image-recording layer thereof according to the invention exhibits good on-press development property and good printing durability and is excellent in not only the plate inspection property just after the exposure but also the plate inspection property at a several hour lapse after the exposure.

**TABLE 1**

| | Mesoporous Silica Having Color Changing Compound Incorporated Therein | Mesoporous Silica | | | Color Changing Compound | Onium Salt | Plate Inspection Property (just after exposure) | Plate Inspection Property (6 hour lapse after exposure) | On-press Development Property (sheets) | Printing Durability (× 10⁴ sheets) |
|---|---|---|---|---|---|---|---|---|---|---|
| | | Pore Size (nm) | Particle Size (nm) | Amount Added (g) | | | | | | |
| Example 1 | 1 | 2 | 200 | 0.25 | Photo-color Changing Compound A | Iodonium Salt A | 4 | 3 | 40 | 3.5 |
| Example 2 | 2 | 4 | 200 | 0.25 | Photo-color Changing Compound A | Iodonium Salt A | 5.5 | 4.5 | 40 | 3.5 |
| Example 3 | 4 | 10 | 200 | 0.25 | Photo-color Changing Compound A | Iodonium Salt A | 5.5 | 4.5 | 40 | 3.5 |
| Example 4 | 5 | 25 | 200 | 0.25 | Photo-color Changing Compound A | Iodonium Salt A | 4.5 | 3.5 | 40 | 3.5 |
| Example 5 | 6 | 50 | 200 | 0.25 | Photo-color Changing Compound A | Iodonium Salt A | 4 | 3 | 40 | 3.5 |
| Example 6 | 7 | 4 | 70 | 0.25 | Photo-color Changing Compound A | Iodonium Salt A | 5.5 | 4.5 | 40 | 3 |
| Example 7 | 8 | 4 | 120 | 0.25 | Photo-color Changing Compound A | Iodonium Salt A | 5.5 | 4.5 | 40 | 3.5 |
| Example 8 | 10 | 4 | 400 | 0.25 | Photo-color Changing Compound A | Iodonium Salt A | 5.5 | 4.5 | 30 | 3 |
| Example 9 | 2 | 4 | 200 | 0.08 | Photo-color Changing Compound A | Iodonium Salt A | 4.5 | 3.5 | 40 | 3.5 |
| Example 10 | 2 | 4 | 200 | 0.17 | Photo-color Changing Compound A | Iodonium Salt A | 5.5 | 4.5 | 40 | 3.5 |
| Example 11 | 2 | 4 | 200 | 0.42 | Photo-color Changing Compound A | Iodonium Salt A | 5.5 | 4.5 | 40 | 3.5 |
| Example 12 | 2A | 4 | 200 | 0.25 | Photo-color Changing Compound A | Iodonium Salt A | 5.5 | 4.5 | 35 | 3.5 |
| Example 13 | 2B | 4 | 200 | 0.25 | Photo-color Changing Compound A | Iodonium Salt A | 5.5 | 4.5 | 35 | 3.5 |
| Example 14 | 2C | 4 | 200 | 0.25 | Photo-color Changing Compound A | Iodonium Salt A | 5.5 | 4.5 | 35 | 3.5 |
| Comparative Example 1 | None | - | - | 0 | None | None | 3.8 | 2 | 40 | 3 |
| Comparative Example 2 | None | - | - | 0 | Photo-color Changing Compound A | Iodonium Salt A | 3.8 | 2 | 80 | 3 |
| Comparative Example 3 | None | 4 | 200 | 0.25 | Photo-color Changing Compound A | Iodonium Salt A | 3.8 | 2 | 40 | 3.5 |

### Examples 15 to 29

Lithographic printing plate precursors for Examples 15 to 29 were prepared in the same manner as in Example 2 excepting for changing the mesoporous silica having color changing compound incorporated therein in Coating solution (A) for image-recording layer in Example 2 to the mesoporous silica having color changing compound incorporated therein shown below, respectively.

### <Preparation of Mesoporous silica 11 to 25 having color changing compound incorporated therein>

Mesoporous silica 11 to 25 having color changing compound incorporated therein were prepared in the same manner as in the preparation of Mesoporous silica 2 having color changing compound incorporated therein described above excepting for changing Photo-color changing compound A and Iodonium salt A to the color changing compound and onium salt shown in Table 2 below, respectively. The color changing compounds and onium salts used are shown below.

### Photo-color changing compound B

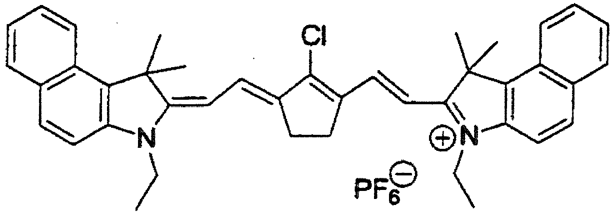

### Photo-color changing compound C

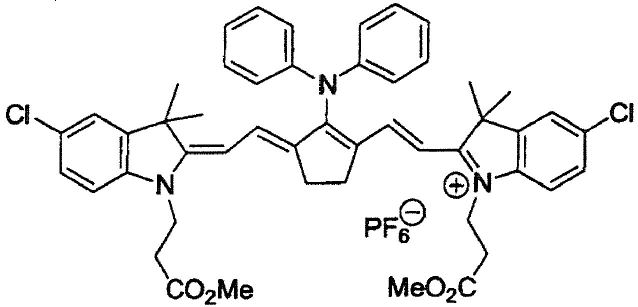

### Photo-color changing compound D

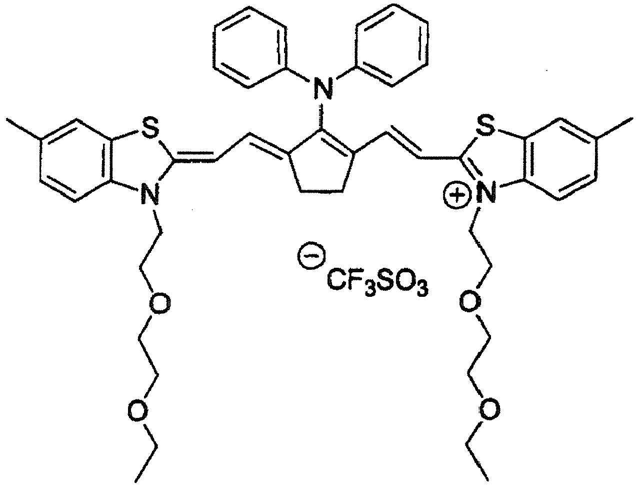

### Sulfonium salt A

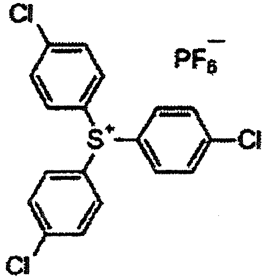

### Sulfonium salt B

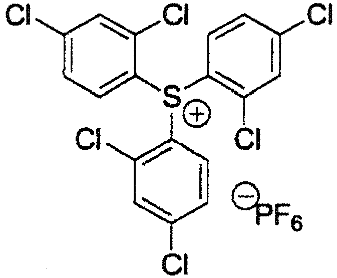

### Heat-color changing compound A (spirooxazine)

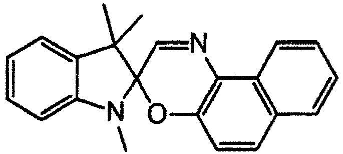

### Heat-color changing compound B (spirooxazine)

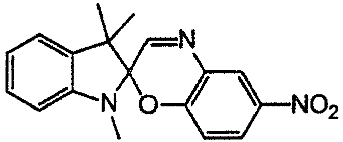

### Heat-color changing compound C (spirooxazine)

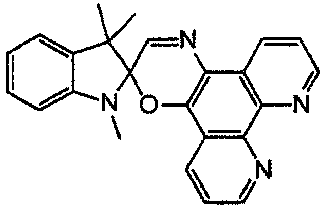

### Heat-color changing compound D (salicyl Schiff base)

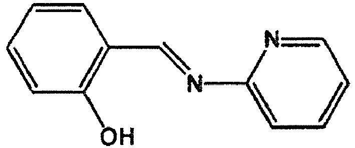

### Acid-color changing compound A (leuco dye)

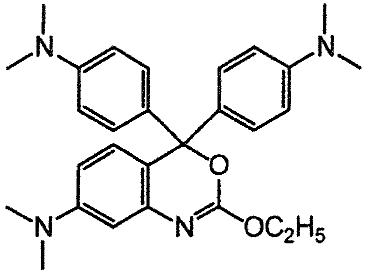

### Acid-color changing compound B (leuco dye)

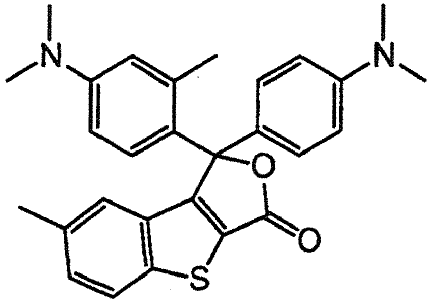

### Acid-color changing compound C (leuco dye)

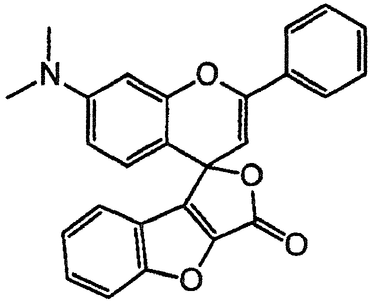

### Acid-color changing compound D (leuco dye)

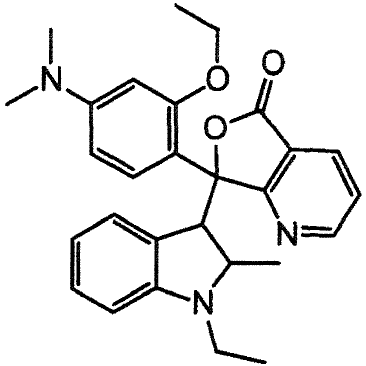

Using the lithographic printing plate precursor prepared, the exposure, on-press development and printing were performed and the plate inspection property, on-press development property and printing durability were evaluated in the same manner as in Example 1. The results obtained are shown in Table 2.

From the results shown in Table 2, it can be seen that even when the color changing compound and onium salt are variously changed in the mesoporous silica having a color changing compound incorporated therein according to the invention, the effect of the invention in that not only the plate inspection property just after the exposure but also the plate inspection property at a several hour lapse after the exposure are excellent and the on-press development property and printing durability are good can be obtained.

**TABLE 2**

| | Mesoporous Silica Having Color Changing Compound Incorporated Therein | Mesoporous Silica | | | Color Changing Compound | Onium Salt | Plate Inspection Property (just after exposure) | Plate Inspection Property (6 hour lapse after exposure) | On-press Development Property (sheets) | Printing Durability (× 10⁴ sheets) |
|---|---|---|---|---|---|---|---|---|---|---|
| | | Pore Size (nm) | Particle Size (nm) | Amount Added (g) | | | | | | |
| Example 15 | 11 | 4 | 200 | 0.25 | Photo-color Changing Compound B | lodonium Salt A | 5.5 | 4.5 | 40 | 3.5 |
| Example 16 | 12 | 4 | 200 | 0.25 | Photo-color Changing Compound C | Iodonium Salt A | 5.5 | 4.5 | 40 | 3.5 |
| Example 17 | 13 | 4 | 200 | 0.25 | Photo-color Changing Compound D | lodonium Salt A | 5.5 | 4.5 | 40 | 3.5 |
| Example 18 | 14 | 4 | 200 | 0.25 | Photo-color Changing Compound A | Sulfonium Salt A | 5 | 4 | 40 | 3.5 |
| Example 19 | 15 | 4 | 200 | 0.25 | Photo-color Changing Compound B | Sulfonium Salt B | 5 | 4 | 40 | 3.5 |
| Example 20 | 16 | 4 | 200 | 0.25 | Photo-color Changing Compound A | None | 4 | 3 | 40 | 3.5 |
| Example 21 | 17 | 4 | 200 | 0.25 | Photo-color Changing Compound B | None | 4 | 3 | 40 | 3.5 |
| Example 22 | 18 | 4 | 200 | 0.25 | Heat-color Changing Compound A | None | 5 | 4 | 40 | 3.5 |
| Example 23 | 19 | 4 | 200 | 0.25 | Heat-color Changing Compound B | None | 5 | 4 | 40 | 3.5 |
| Example 24 | 20 | 4 | 200 | 0.25 | Heat-color Changing Compound C | None | 5 | 4 | 40 | 3.5 |
| Example 25 | 21 | 4 | 200 | 0.25 | Heat-color Changing Compound D | None | 5 | 4 | 40 | 3.5 |
| Example 26 | 22 | 4 | 200 | 0.25 | Acid-color Changing Compound A | None | 5 | 4 | 40 | 3.5 |
| Example 27 | 23 | 4 | 200 | 0.25 | Acid-color Changing Compound B | None | 5 | 4 | 40 | 3.5 |
| Example 28 | 24 | 4 | 200 | 0.25 | Acid-color Changing Compound C | None | 5 | 4 | 40 | 3.5 |
| Example 29 | 25 | 4 | 200 | 0.25 | Acid-color Changing Compound D | None | 5 | 4 | 40 | 3.5 |

### Examples 30 to 40 and Comparative Examples 4 and 5

### [Preparation of Lithographic printing plate precursors (30) and (31)]

Lithographic printing plate precursors (30) and (31) were prepared in the same manner as in Example 1 excepting for changing Coating solution (A) for image-recording layer to Coating solution (C) for image-recording layer shown below.

Coating solution (C) for image-recording layer was prepared by mixing Photosensitive liquid (2) shown below, Microgel liquid (1) shown above and 0.25 g of Mesoporous silica 2 having color changing compound incorporated therein shown above just before the coating, followed by stirring.

### <Photosensitive liquid (2)>

| | |
|---|---|
| Binder polymer (1) having structure shown above | 0.240 g |
| Infrared absorbing agent (1) having structure shown above | 0.030 g |
| Radical generator (1) having structure shown above | 0.162 g |
| Polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (1) (Tris(2-hydroxyethyl) isocyanurate) | 0.062 g |
| Hydrophilic low molecular weight compound (2) having structure shown above | 0.050 g |
| Oil-sensitizing agent (1) (Phosphonium compound (1) having structure shown above) | 0.055 g |
| Oil-sensitizing agent (2) (Benzyl dimethyl octyl ammonium PF₆ salt) | 0.018 g |
| Oil-sensitizing agent (3) (Ammonium group-containing polymer having structure shown above (reduced specific viscosity: 44 cSt/g/ml) | 0.035 g |
| Fluorine-based surfactant (1) having structure shown above | 0.008 g |
| Borate compound A or B having structure shown below | 0.25 g |
| 2-Butanone | 1.091 g |
| 1-Methoxy-2-propanol | 8.609 g |

### Borate compound A

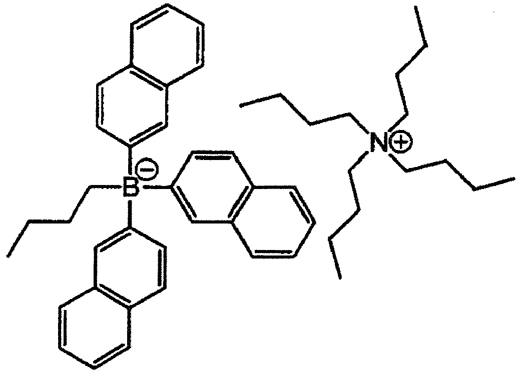

### Borate compound B

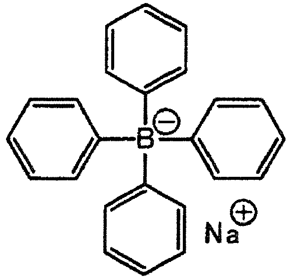

### [Preparation of Lithographic printing plate precursors (32) to (34)]

Coating solution (1) for protective layer having the composition shown below was further coated on the image-recording layer of Lithographic printing plate precursors (2), (30) and (31) by a bar and dried in an oven at 120°C for 60 seconds to form a protective layer having a dry coating amount of 0.15 g/m², thereby preparing Lithographic printing plate precursors (32) to (34), respectively.

### <Coating solution (1) for protective layer>

| | |
|---|---|
| Dispersion (1) of inorganic stratiform compound shown below | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

### <Preparation of Dispersion (1) of inorganic stratiform compound>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 µm. The aspect ratio of the inorganic particle thus-dispersed was 100 or more.

### [Preparation of Lithographic printing plate precursor (35)

Lithographic printing plate precursor (35) was prepared in the same manner as in Lithographic printing plate precursor (2) described above excepting for using Coating solution (D) for image-recording layer shown below in place of Coating solution (A) for image-recording layer.

Coating solution (D) for image-recording layer was prepared by mixing Photosensitive liquid (3) shown below and 0.25 g of Mesoporous silica 2 having color changing compound incorporated therein shown above just before the coating, followed by stirring.

### <Photosensitive liquid (3)>

| | |
|---|---|
| Aqueous dispersion (1) of polymer fine particle shown below | 20.0 g |
| Infrared absorbing agent (2) having structure shown below | 0.2g |
| Radical generator (IRGACURE 250, produced by BASF) | 0.5 g |
| Polymerizable compound (SR-399, produced by Sartomer Co.) | 1.50 g |
| Mercapto-3-triazole | 0.2 g |
| BYK 336 (produced by BYK-Chemie GmbH) | 0.4 g |
| KLUCEL M (produced by Hercules Chemical Co., Inc.) | 4.8 g |
| ELVACITE 4026 (produced by Ineos Acrylics Inc.) | 2.5 g |
| n-Propanol | 55.0 g |
| 2-Butanone | 17.0 g |

The compounds indicated using their trade names in Photosensitive liquid (3) described above are shown below.
IRGACURE 250: (4-Methylphenyl)[4-(2-methylpropyl)phenyl]iodonium hexafluorophosphate (75% by weight propylene carbonate solution)
SR-399: Dipentaerythritol pentaacrylate
BYK 336: Modified dimethylpolysiloxane copolymer (25% by weight xylene/methoxypropyl acetate solution)
KLUCEL M: Hydroxypropyl cellulose (2% by weight aqueous solution)
ELVACITE 4026: Highly branched polymethyl methacrylate (10% by weight 2-butanone solution) 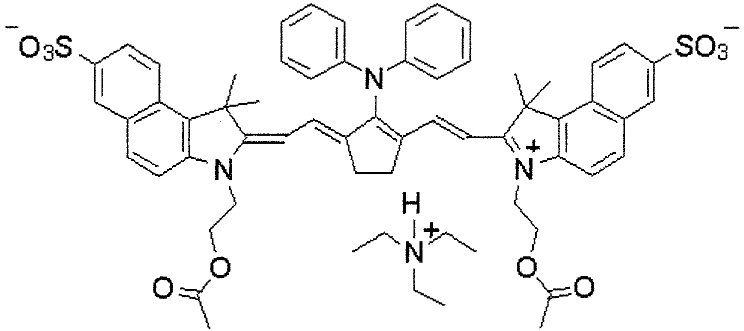
Infrared absorbing agent (2)

### (Preparation of Aqueous dispersion (1) of polymer fine particle)

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded to 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

### [Preparation of Lithographic printing plate precursors (36) and (37)]

Lithographic printing plate precursors (36) and (37) were prepared in the same manner as in Lithographic printing plate precursor (35) described above excepting for using Coating solution (E) for image-recording layer shown below in place of Coating solution (D) for image-recording layer.

Coating solution (E) for image-recording layer was prepared by mixing Photosensitive liquid (4) shown below and 0.25 g of Mesoporous silica 2 having color changing compound incorporated therein shown above just before the coating, followed by stirring.

### <Photosensitive liquid (4)>

| | |
|---|---|
| Aqueous dispersion (1) of polymer fine particle shown above | 20.0 g |
| Infrared absorbing agent (2) having structure shown above | 0.2g |
| Radical generator (IRGACURE 250, produced by BASF) | 0.5 g |
| Polymerizable compound (SR-399, produced by Sartomer Co.) | 1.50 g |
| Mercapto-3-triazole | 0.2 g |
| BYK 336 (produced by BYK-Chemie GmbH) | 0.4 g |
| KLUCEL M (produced by Hercules Chemical Co., Inc.) | 4.8 g |
| ELVACITE 4026 (produced by Ineos Acrylics Inc.) | 2.5 g |
| Borate compound A or B having structure shown above | 0.25 g |
| n-Propanol | 55.0 g |
| 2-Butanone | 17.0 g |

### [Preparation of Lithographic printing plate precursors (38) to (40)]

Coating solution (1) for protective layer shown above was further coated on the image-recording layer of Lithographic printing plate precursors (35) to (37) by a bar and dried in an oven at 120°C for 60 seconds to form a protective layer having a dry coating amount of 0.15 g/m², thereby preparing Lithographic printing plate precursors (38) to (40), respectively.

### [Preparation of Lithographic printing plate precursors (R4) and (R5) for comparison]

Lithographic printing plate precursor (R4) for Comparative Example 4 was prepared in the same manner as in Lithographic printing plate precursor (35) described above excepting for eliminating the mesoporous silica having color changing compound incorporated therein in Coating solution (D) for image-recording layer and in place thereof adding 4 × 10⁻³ mol of Photo-color changing compound A and 4 × 10⁻³ mol of Iodonium salt A.

Lithographic printing plate precursor (R5) for Comparative Example 5 was prepared in the same manner as in Lithographic printing plate precursor (35) described above excepting for eliminating the mesoporous silica having color changing compound incorporated therein in Coating solution (A) for image-recording layer and in place thereof adding 0.25 g of Mesoporous silica particle 2 (particle size: 200 nm, pore size: 4 nm, produced by Sigma-Aldrich Co.), 4 × 10⁻³ mol of Photo-color changing compound A and 4 × 10⁻³ mol of Iodonium salt A.

Using the lithographic printing plate precursor prepared, the exposure, on-press development and printing were performed and the plate inspection property, on-press development property and printing durability were evaluated in the same manner as in Example 1. The results obtained are shown in Table 3.

From the results shown in Table 3, it can be seen that even when the composition of the image-recording layer is changed or even when the protective layer is provided on the image-recording layer, the effect of the invention in that not only the plate inspection property just after the exposure but also the plate inspection property at a several hour lapse after the exposure are excellent and the on-press development property and printing durability are good can be obtained.

**TABLE 3**

| | Mesoporous Silica Having Color Changing Compound Incorporated Therein | Mesoporous Silica | | | Color Changing Compound | Onium Salt | Borate Compound | Protective Layer | Plate Inspection Property (just after exposure) | Plate Inspection Property (6 hour lapse after exposure) | On-press Development Property (sheets) | Printing Durability (× 10⁴ sheets) |
|---|---|---|---|---|---|---|---|---|---|---|---|---|
| | | Pore Size (nm) | Particle Size (nm) | Amount Added (g) | | | | | | | | |
| Example 30 | 2 | 4 | 200 | 0.25 | Photo-color Changing Compound A | Iodonium Salt A | Borate A | Absence | 5.5 | 4.5 | 40 | 5 |
| Example 31 | 2 | 4 | 200 | 0.25 | Photo-color Changing Compound A | Iodonium Salt A | Borate B | Absence | 5.5 | 4.5 | 40 | 5.5 |
| Example 32 | 2 | 4 | 200 | 0.25 | Photo-color Changing Compound A | Iodonium Salt A | None | Presence | 5.5 | 4.5 | 40 | 4.5 |
| Example 33 | 2 | 4 | 200 | 0.25 | Photo-color Changing Compound A | Iodonium Salt A | Borate A | Presence | 5.5 | 4.5 | 40 | 6 |
| Example 34 | 2 | 4 | 200 | 0.25 | Photo-color Changing Compound A | Iodonium Salt A | Borate B | Presence | 5.5 | 4.5 | 40 | 6.5 |
| Example 35 | 2 | 4 | 200 | 0.25 | Photo-color Changing Compound A | Iodonium Salt A | None | Absence | 5.5 | 4.5 | 40 | 3.5 |
| Example 36 | 2 | 4 | 200 | 0.25 | Photo-color Changing Compound A | Iodonium Salt A | Borate A | Absence | 5.5 | 4.5 | 40 | 5.5 |
| Example 37 | 2 | 4 | 200 | 0.25 | Photo-color Changing Compound A | Iodonium Salt A | Borate B | Absence | 5.5 | 4.5 | 40 | 6 |
| Example 38 | 2 | 4 | 200 | 0.25 | Photo-color Changing Compound A | Iodonium Salt A | None | Presence | 5.5 | 4.5 | 30 | 4.5 |
| Example 39 | 2 | 4 | 200 | 0.25 | Photo-color Changing Compound A | Iodonium Salt A | Borate A | Presence | 5.5 | 4.5 | 40 | 6 |
| Example 40 | 2 | 4 | 200 | 0.25 | Photo-color Changing Compound A | Iodonium Salt A | Borate B | Presence | 5.5 | 4.5 | 40 | 6.5 |
| Comparative Example 4 | None | - | - | 0 | Photo-color Changing Compound A | Iodonium Salt A | None | Absence | 3.8 | 2 | 80 | 3.5 |
| Comparative Example 5 | None | 4 | 200 | 0.25 | Photo-color Changing Compound A | Iodonium Salt A | None | Absence | 3.8 | 2 | 40 | 3.5 |

## Claims

1. A lithographic printing plate precursor comprising a support and an image-recording layer capable of forming an image by removing an unexposed area by supplying printing ink and dampening water on a printing machine after image exposure, wherein the image-recording layer comprises (A) an infrared absorbing agent, (B) a radical generator, (C) a polymerizable compound and (D) a mesoporous silica having a color changing compound incorporated in the mesoporous silica.

2. The lithographic printing plate precursor as claimed in Claim 1, wherein the color changing compound incorporated in the mesoporous silica is a compound which causes change in color with light, an acid or heat.

3. The lithographic printing plate precursor as claimed in Claim 2, wherein the color changing compound is a compound which causes change in color with light.

4. The lithographic printing plate precursor as claimed in Claim 3, wherein the compound which causes change in color with light is a cyanine dye.

5. The lithographic printing plate precursor as claimed in Claim 4, wherein the cyanine dye is a cyanine dye represented by the following formula (2): 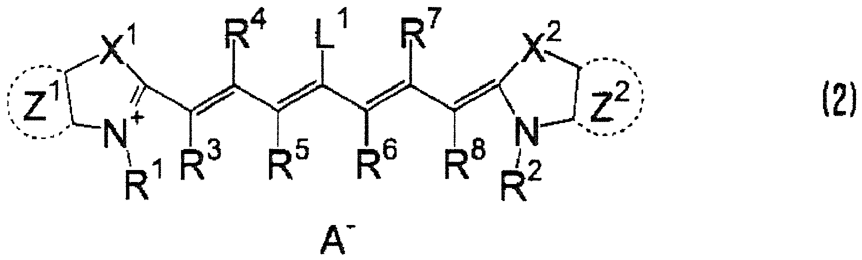 wherein L¹ represents a hydrogen atom, a halogen atom, -NPh₂ or -Y³-L², Y³ represents an oxygen atom, a nitrogen atom or a sulfur atom, L² represents an alkyl group, an aryl group, a heterocyclic group or a hydrocarbon group having from 1 to 12 carbon atoms and containing a hetero atom, X¹ and X² each independently represents a sulfur atom, an oxygen atom or a dialkylmethylene group having 12 or less carbon atoms, Z¹ and Z² each independently represents an aromatic ring or a hetero aromatic ring, R¹ and R² each independently represents a hydrocarbon group, R³, R⁴, R⁷ and R⁸ each independently represents a hydrogen atom or a hydrocarbon group having 12 or less carbon atoms, R⁵ and R⁶ each independently represents a hydrocarbon group, or R⁵ and R⁶ may be combined with each other to form a 5-membered or 6-membered ring, and A⁻ represents a counter anion.

6. The lithographic printing plate precursor as claimed in Claim 5, wherein the cyanine dye is a cyanine dye represented by the following formula (3): 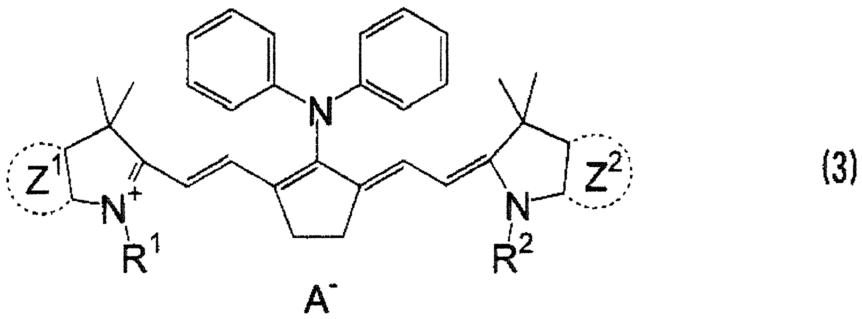 wherein Z¹ and Z² each independently represents an aromatic ring or a hetero aromatic ring, R¹ and R² each independently represents a hydrocarbon group, and A⁻ represents a counter anion.

7. The lithographic printing plate precursor as claimed in any one Claims 4 to 6, wherein the mesoporous silica having the cyanine dye incorporated in the mesoporous silica further has an onium salt incorporated in the mesoporous silica.

8. The lithographic printing plate precursor as claimed in Claim 7, wherein the onium salt is an iodonium salt or a sulfonium salt.

9. The lithographic printing plate precursor as claimed in Claim 2, wherein the color changing compound is a compound which causes change in color with an acid.

10. The lithographic printing plate precursor as claimed in Claim 9, wherein the compound which causes change in color with an acid is a compound represented by the following formula (II-3): 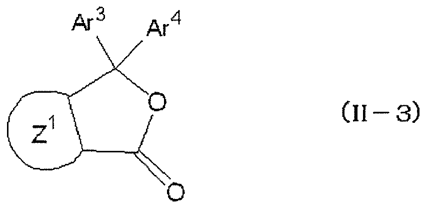 wherein Ar³ and Ar⁴, which may be same or different, each represents an aryl group, a heterocyclic group, an alkenyl group or an alkynyl group, and Z¹ represents an aromatic hydrocarbon ring or a heterocyclic ring.

11. The lithographic printing plate precursor as claimed in Claim 2, wherein the color changing compound is a compound which causes change in color with heat.

12. The lithographic printing plate precursor as claimed in Claim 11, wherein the compound which causes change in color with heat is a compound represented by the following formula (IB): 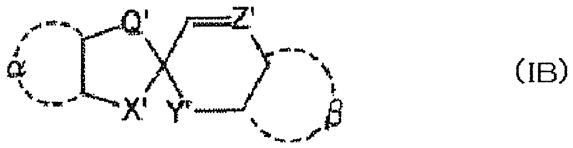 wherein X' represents NR¹, O or S, R¹ represents an alkyl group having from 1 to 20 carbon atoms, an alkenyl group having from 2 to 20 carbon atoms, an alkynyl group having from 2 to 20 carbon atoms, an aralkyl group having from 7 to 20 carbon atoms or an aryl group having from 6 to 19 carbon atoms, α and β each represents an atomic group which forms a ring together with the carbon atoms connected, Q' represents O, S or CR²R³, R² and R³ each independently represents an alkyl group having from 1 to 20 carbon atoms, an alkenyl group having from 2 to 20 carbon atoms, an alkynyl group having from 2 to 20 carbon atoms, an aralkyl group having from 7 to 20 carbon atoms or an aryl group having from 6 to 19 carbon atoms, or R² and R³ may be combined with each other to from a ring having from 3 to 20 carbon atoms, Y' represents N, O or S, and Z' represents CH or N.

13. The lithographic printing plate precursor as claimed in any one of Claims 1 to 12, wherein the image-recording layer comprises (F) a borate compound.

14. The lithographic printing plate precursor as claimed in Claim 13, wherein the borate compound is a tetraaryl borate.

15. The lithographic printing plate precursor as claimed in any one of Claims 1 to 14, which comprises a protective layer on the image-recording layer.

16. A plate making method comprising: imagewise exposing the lithographic printing plate precursor as claimed in any one of Claims 1 to 15 with infrared laser; mounting the exposed lithographic printing plate precursor on a printing machine; and supplying dampening water and ink to remove the image-recording layer in an unexposed area.
